# EUROPEAN PATENT SPECIFICATION

(11) **EP 3 093 368 B1**
(45) Date of publication and mention of the grant of the patent: **10.11.2021**
(21) Application number: 15735432.5
(22) Date of filing: 09.01.2015
(51) Int. Cl.: C23C 16/455

(54) **CHEMICAL VAPOR DEPOSITION DEVICE, AND CHEMICAL VAPOR DEPOSITION METHOD**
VORRICHTUNG UND VERFAHREN ZUR CHEMISCHEN DAMPFPHASENABSCHEIDUNG
DISPOSITIF DE DÉPÔT CHIMIQUE EN PHASE VAPEUR ET PROCÉDÉ DE DÉPÔT CHIMIQUE EN PHASE VAPEUR

(30) Priority: 10.01.2014 JP 2014003251; 22.12.2014 JP 2014259387
(43) Date of publication of application: 16.11.2016
(73) Proprietor: Mitsubishi Materials Corporation, Chiyoda-ku, Tokyo 100-8117 (JP)
(72) Inventor: TATSUOKA Sho, Naka-shi Ibaraki 311-0102 (JP); YAMAGUCHI Kenji, Naka-shi Ibaraki 311-0102 (JP)
(74) Representative: Gille Hrabal Partnerschaftsgesellschaft mbB Patentanwälte
(86) International application number: PCT/JP2015/050488
(87) International publication number: WO 2015/105177

(56) References cited:
- WO-A1-2014/003437
- JP-A- S63 479
- JP-A- S5 972 721
- JP-A- H05 295 548
- JP-A- 2011 528 753
- JP-A- 2013 089 818
- JP-A- 2014 128 848
- US-A- 6 158 382
- US-A1- 2012 103 260
- None

## Description

### Technical Field

The present invention relates to a chemical vapor deposition apparatus and a chemical vapor deposition method.

### Background Art

The cutting tool, the surface of which is coated by the hard layer is conventionally known. For example, the surface-coated cutting tool with a body made of WC-based cemented carbide and coated on its surface by a hard layer such as TiC, TiN, and the like by a chemical vapor deposition method is known. As an apparatus for the coating treatment of the hard layer on the surface of the cutting tool body, the chemical vapor deposition apparatuses described in Patent Literatures 1 to 3 (PTLs 1 to 3) are known.

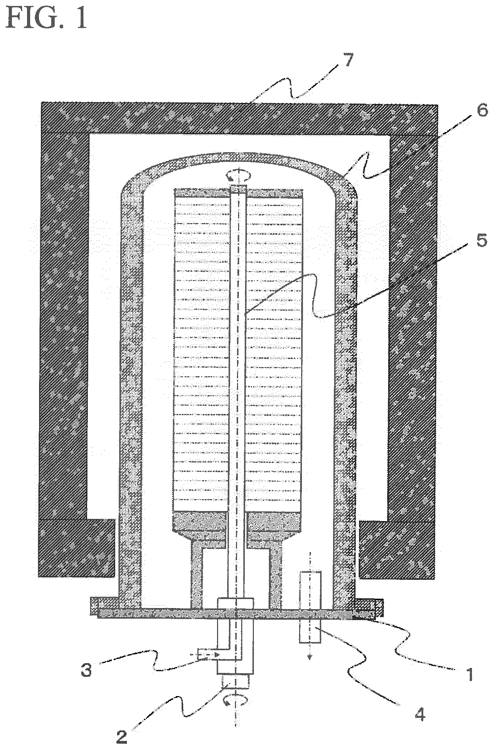

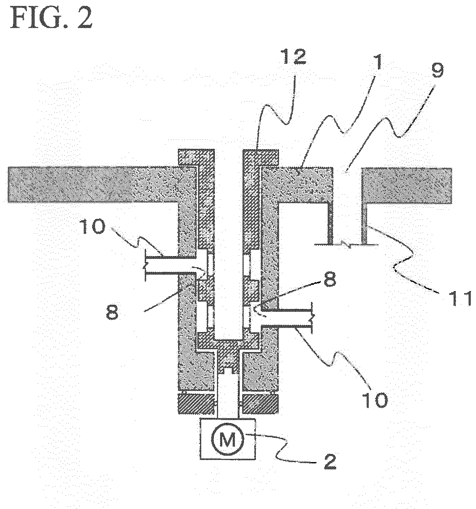

A schematic side view of the conventionally known vertical-vacuum chemical vapor deposition apparatus is shown in FIG. 1. In FIG. 2, a schematic side view of an example of the baseplate and peripheral parts used in the vertical-vacuum chemical vapor deposition apparatus.

By using FIGS. 1 and 2, the outline of the conventional vertical-vacuum chemical vapor deposition apparatus is explained.

The conventional vertical-vacuum chemical vapor deposition apparatus has the baseplate 1 and the bell-shaped reaction chamber 6 as shown in FIG. 1. After attaching the cutting tool bodies by fixing jigs provided in the space in the reaction chamber 6, it is air-tight sealed. Then, the outer wall of the reaction chamber 6 is covered by the outside thermal heater 7 to heat the inside of the reaction chamber 6 to about 700 to 1050°C. Then, chemical vapor deposition on the cutting tool body, such as coating treatment or the like, is performed by: introducing various mixed gases continuously from the gas feeding part 3 provided to the baseplate 1 and the gas inlet 8; and operating exhaustion of the reacted gas to the gas exhaust part 4 and the gas outlet 9 as shown in FIGS. 1 and 2.

At this time, in order to depressurize the pressure in the reaction chamber 6 and to keep the reduced pressure state, the exhaustion gas is forcibly exhausted from the inside of the reaction chamber 6 by using a vacuum pump.

Each of the gas feeding part 3, the gas inlet 8, the gas exhaust part 4, and the gas outlet 9 is provided to the baseplate 1 at a single location. However, there is a case in which exhaustion is done by another vacuum pump separately provided to other outlet for vacuuming in order to evacuate the air in the reaction chamber 6 after attaching the cutting tool bodies in the reaction chamber 6.

Furthermore, there is a case where the through-hole is provided to the baseplate for inserting the thermocouple temperature sensor when it is necessary to monitor the temperature in the reaction chamber 6.

In addition, in order to improve uniformity of the coating, the mixed gas introduced from the gas feeding part 3 to the gas inlet 8 is introduced in the rotary gas introduction part 12, which is driven to rotate by the rotary drive device 2; and supplied to the inside of the reaction chamber from the rotating gas supply tube 5 through the gas supply tube 5 connected to the rotary gas introduction part 12.

The surface of the cutting tool body is coated by the hard layer with the above-described vertical-vacuum chemical vapor deposition apparatus shown in FIGS. 1 and 2 by the chemical vapor deposition method. The mixed gas used for coating is a mixed gas of: a chlorine gas including at least one of TiCl₄ and AlCl₃; and a gas including at least one of CH₄, N₂, H₂, CH₃CN, CO₂, CO, HCl, H₂S, and the like, for example. It is known that by performing chemical vapor deposition using this mixed gas as the reactant gas, the hard layer of TiC, TiCN, TiN, Al₂O₃, or the like is coated.

In the vertical-vacuum chemical vapor deposition apparatus shown in FIG. 1, the gas feeding part 3 is formed in a single location in the central part of the baseplate 1. On the other hand, in order to avoid troubles on the operation due to occlusion in the gas inlet and to perform the chemical vapor deposition safely, the vertical-vacuum chemical vapor deposition apparatus, in which the gas inlets 8 are placed on 2 locations (or more than 2 locations) by changing their vertical height positions on the side part of the gas feeding part provided to the central part of the baseplate as shown in FIG 2, is proposed.

For example, placing gas inlets on 2 locations or more than 2 locations on the side part of the gas feeding part provided to the central part of the baseplate by changing their vertical height positions; and providing gas outlets to the baseplate on 2 locations or more than 2 locations, are proposed in Patent Literature 3 (PTL 3).

A further chemical vapor deposition apparatus for supplying multiple gases is known from Patent Literature 4 (PTL 4).

### Citation List

### Patent Literature

PTL 1: Japanese Unexamined Patent Application, First Publication No. H05-295548 (A)
PTL 2: Published Japanese Translation No. 2011-528753 of the PCT International Publication (A)
PTL 3: Japanese Unexamined Patent Application, First Publication No. H09-310179 (A)
PTL 4: WO2014003437 A1

### Summary of Invention

### Technical Problem

In the chemical vapor deposition apparatuses described in PTLs 1 and 2, the raw material gas is dispersed by: stacking trays, on which the cutting tool bodies are placed, in the reaction chamber; and rotating the gas supply tube extended in the vertical direction in the vicinity to the trays. In addition, in PTL3, the vertical-vacuum chemical vapor deposition apparatus, in which gas inlets are placed on 2 locations or more than 2 locations on the baseplate in order to avoid troubles on the operation due to occlusion in the gas inlet and to perform the chemical vapor deposition safely, is proposed. However, in the case where gas species that are highly reactive each other are used, the raw material gases are likely to react in the supply route. As a result, reaction products formed by the reaction between the raw material gases are deposited on the inside of the gas supply tube or the gas ejection port to be occlusions in supplying the gases occasionally. Consequently, there was an occasion that the gases react unevenly; and uniformity of the quality of the films in each of cutting tools in the reaction chamber is deteriorated.

One of the purposes of the present invention is to provide a chemical vapor deposition apparatus capable of forming uniform coating films on multiple deposition materials and a chemical vapor deposition method. In this context, "uniform coating films" mean that the thickness of the films is uniform; the composition of films is uniform; or the thickness and the composition of the films are uniform at the same time.

Under the circumstances described above, the inventors of the present invention made findings below about the condition necessary for uniformly depositing over the large deposition area by a chemical vapor deposition apparatus without forming: occlusions in the gas supply tube; and deposits around the gas ejection port.

First, in the case where deposition is performed by using gas species that are highly reactive each other as raw material gas groups, it is necessary that these gas species are kept being separated in the gas supply tube without being mixed together; and each of the separated gases is ejected individually from the rotating gas supply tube.

Second, it is necessary that the individually ejected gases are mixed in the space, which is in the reaction chamber and outer side from the gas supply tube, after gases being ejected; and at least a part of the gas ejection port of each of the separated gases intersects the plane having the normal line corresponding to the rotation axis of the rotating gas supply tube (in other words, the gas ejection port of each of the separated gases forms a plane roughly perpendicular to the rotation axis of the gas supply tube).

Third, in terms of the rotating gas supply tube, it is necessary that proceeding of mixing of gases and the travel time of the gases to the surface of the cutting tool body are adjustable by configuring that the rotation speed of the gas supply tube is appropriately controlled.

However, even if the gas species that are highly reactive each other are kept being separated in the gas supply tube without mixing them together; and gases are mixed after ejection of the gases from the rotating gas supply tube, for example, in the case where the proceeding of mixing of gas species that are highly reactive each other is faster than the travel time of the gases to the surfaces of the cutting tool bodies, thick films are deposited only on the deposition materials near the gas ejection ports, and it is impossible to obtain uniform coating films over the intended region having a large area. On the other hand, in the case where the proceeding of mixing of gas species that are highly reactive each other is slower than the travel time of the gases to the surfaces of the cutting tool bodies, almost no film is deposited on the deposition materials near the gas ejection ports and it is impossible to obtain uniform coating films over the intended region having a large area in a similar fashion.

Accordingly, the inventors of the present invention conducted extensive studies on the positional relationship of the ejection ports for gas groups of the 2 separated systems during mixing the gases after the gases being ejected from the rotating gas supply tube. As a result, the inventors of the present invention found that the goal for obtaining the uniform coating films over the large area cannot be achieved simply by relying on mixing by diffusion after gas ejection. In addition, they found that the goal for obtaining the uniform coating films over the deposition region with a large area can be achieved by configuring the chemical vapor deposition apparatus in such a way that gases of the gas groups of the 2 separated systems are mixed near the surfaces of the cutting tool bodies after ejection by the revolving component of the rotation movement of the gas supply tube.

Then, they found that there are optimum ranges in conditions of: the distance and the angle defining the positional relationship between the ejection ports; the rotation speed of the gas supply tube; and the like in order to achieve the goal for obtaining the uniform coating films over the large area by using the chemical vapor deposition apparatus that is configured as described above.

### Solution to Problem

In order to solve the above-described technical problems, the present invention is disclosed in the appended apparatus claims 1-9 and appended method claims 10-13.

### Advantageous Effects of Invention

According to the chemical vapor deposition apparatus and the chemical vapor deposition method, which are aspects of the present invention, occlusion of the gas supply tube and formation of deposits near the gas ejection port can be suppressed; and uniform coating films can be formed over the deposition region with a large area, even in the conventionally difficult case where deposition is performed using gas species that are highly reactive each other as raw material gas groups.

More specifically, according to aspects of the present invention, a chemical vapor deposition apparatus capable of forming uniform coating films on multiple deposition materials and a chemical vapor deposition method are provided.

### Brief Description of Drawings

FIG. 1 is a schematic side view of a conventional vertical-vacuum chemical vapor deposition apparatus.
FIG. 2 is a schematic side view of the baseplate 1 to which 2 gas inlets are provide and a peripheral portion of the baseplate 1 in a conventional vertical-vacuum chemical vapor deposition apparatus.
FIG. 3 is a schematic cross-sectional view of a cross-section perpendicular to the rotation axis 22 of the gas supply tube 5
FIG. 4 is a schematic cross-sectional view of a cross-section perpendicular to the rotation axis 22 of the gas supply tube 5
FIG. 5 is a schematic perspective view of the gas supply tube 5
FIG. 6 is a schematic perspective view of a gas supply tube 5
FIG. 7 is a schematic view showing the plane 23 having the normal line corresponding to the rotation axis 22 of the gas supply tube 5
FIG. 8A is a schematic view showing the case in which the ejection ports are provided in such a way that the plane 23, which has the normal line corresponding to the rotation axis 22 of the gas supply tube 5 and both the ejection port A (16) and the ejection port B (17), which form the pair 24, intersect in the gas supply tube 5
FIG. 8B is a schematic view showing the case in which the ejection ports are provided in such a way that the plane 23, which has the normal line corresponding to the rotation axis 22 of the gas supply tube 5 and both the ejection port A (16) and the ejection port B (17), which form the pair 24, intersect in the gas supply tube 5
FIG. 8C is a schematic view showing the case in which the ejection ports are provided in a placement/arrangement out of the scope of the present invention. In this case, the plane 23, which has the normal line corresponding to the rotation axis 22 of the gas supply tube 5 and both the ejection port A (16) and the ejection port B (17), which form the pair 24, do not intersect.
FIG. 9 is a schematic view showing the relationship of the view point A and the view point B, which are view from 2 different directions in the cross section perpendicular to the rotation axis 22 of the gas supply tube 5
FIG. 10A is a schematic perspective view of the gas supply tube 5 viewed from the view point A and shows that the ejection port pairs 25 are provided in such a way that the gas supply tube 5 rotates so as the ejection port A to precede relative to the rotation direction.
FIG. 10B is a schematic perspective view of the gas supply tube 5 viewed from the view point B and shows that the ejection port pairs 26 are provided in such a way that the gas supply tube 5 rotates so as the ejection port B to precede relative to the rotation direction.
FIG. 11 is a schematic side view showing an example of the baseplate 1 and the peripheral part. They are for: introducing the raw material gas groups A and B from the gas ejection inlets 27, 28 by using the baseplate 1 to which the gas inlets 27, 28 are provided on 2 locations; and supplying each of the gases to 2 sections, the section A and the section B, which are divided sections in the gas supply tube 5, without mixing them, while the raw material gas groups A and B are not mixed in the rotary gas introduction part 12.
FIG. 12 is a cross-sectional view of the chemical vapor deposition apparatus related to an embodiment of the present invention.
FIG. 13 is a cross-sectional view of the gas supply tube and the rotary drive device.
FIG. 14 is a horizontal cross-sectional view of the gas supply tube.
FIG. 15 is a partial perspective view of the gas supply tube.
FIG. 16A is an explanatory diagram of arrangement of the gas ejection ports.
FIG. 16B is an explanatory diagram of arrangement of the gas ejection ports.
FIG 16C is an explanatory diagram of arrangement of the gas ejection ports.
FIG. 17 is a cross-sectional view for explaining the arrangement of the gas ejection ports.
FIG. 18A is a perspective view for explaining the arrangement of the gas ejection ports.
FIG. 18B is a a perspective view for explaining the arrangement of the gas ejection ports.
FIG. 19 is a cross-sectional view showing another example of the gas supply tube.

### Description of Embodiments

### [First Embodiment]

The chemical vapor deposition apparatus and the chemical vapor deposition are explained in detail in reference to drawings below.

In each of drawings, the identical components of the apparatus are labeled by the same reference symbols.

The present invention can be applied to a vacuum chemical vapor deposition apparatus and a chemical vapor deposition method for manufacturing surface-coated cutting tools or the like with a cutting tool body made of WC-based cemented carbide, TiCN-based cermet, Si₃N₄-based ceramics, Al₂O₃-based ceramics, or cBN-based ultra-high-pressure sintered material, a surface of which is coated by a hard layer. A vacuum chemical vapor deposition apparatus includes the baseplate 1; the bell-shaped reaction chamber 6 ; and the outside thermal heater 7 as the basis configuration of the apparatus as shown in FIG 1.

In the reaction chamber 6 of the apparatus, the space, in which jigs for attaching the cutting tools are fixed, is formed.

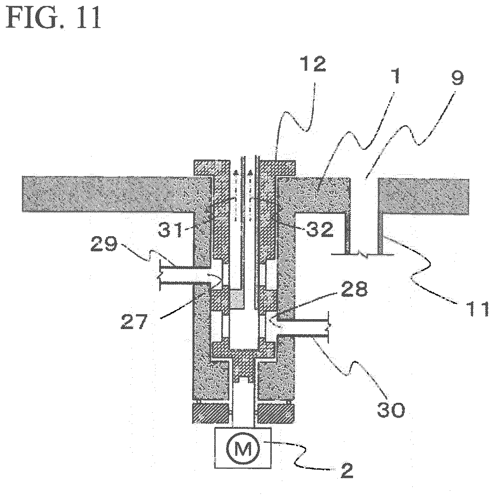

On the outer wall of the reaction chamber 6, the outside thermal heater 7 for heating the inside of the reaction chamber 6 to about 700°C to 1050°C is attached. The raw material gas group A inlet 27; the raw material gas group B inlet 28; and the gas outlet 9 are provided to the baseplate 1; and each of them are connected to: the raw material gas group A inlet pipe 29; the raw material gas group B inlet pipe 30; and the gas exhaust pipe 11, respectively, as shown in FIG. 11.

To the central bottom part of the baseplate 1, the rotary gas introduction part 12 for giving rotation movement to the introduced gases and the rotary drive device 2 for rotating the rotary gas introduction part 12 are connected through a coupling.

As shown in FIG. 11, the raw material gas group A inlet 27 and the raw material gas group B inlet 28 are attached by changing their vertical height positions on the side part of the gas feeding part provided to the central part of the baseplate 1 protruding in the downward direction in the apparatus. The gases are supplied to the central part of the rotary gas introduction part from the holes provided on the side surface of the rotary gas introduction part 12 inserted in the gas feeding part. On this occasion, the apparatus is configured in such way that the raw material gas group A inlet 27 and the raw material gas group B inlet 28 are attached by changing their vertical height positions; each of the raw material gas group A and the raw material gas group B is introduced one of two separated spaces even in the rotary gas introduction part 12; and the raw material gas group A and the raw material gas group B are introduced to the gas supply tube 5 connected to the gas introduction part 12 by passing through the raw material gas group A introduction path 31 and the raw material gas group B introduction path 32, respectively.

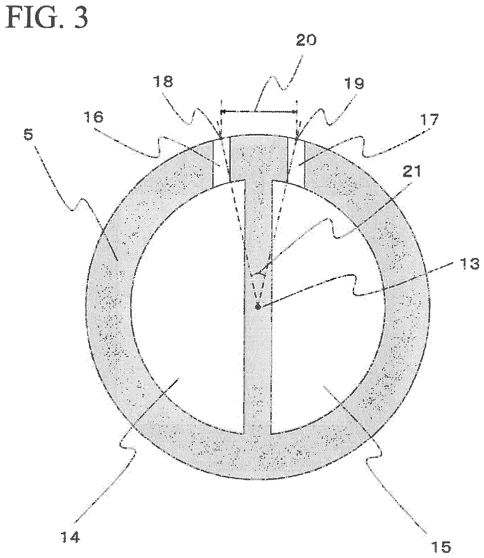

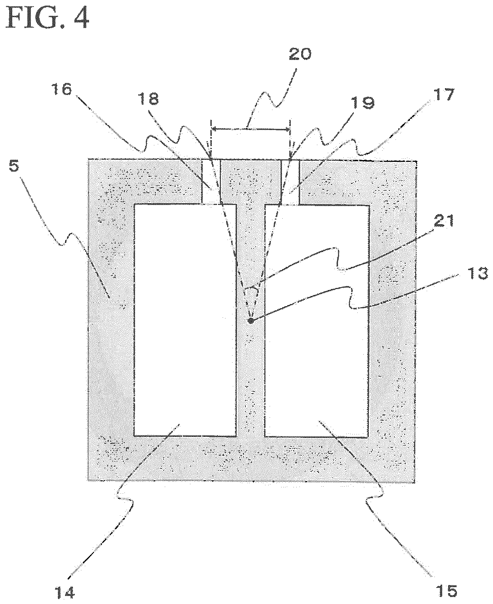

The gas supply tube 5 has 2 divided sections, the section A (14) and the section B (15) as shown in FIGS. 3 and 4. The raw material gas group A is supplied to the section A (14), and the raw material gas group B is supplied to the section B (15).

The raw material gas group A ejected from the ejection port A (16) provided to the section A (14); and the raw material gas group B ejected from the ejection port B (17) provided to the section B (15) are mixed in outer side from the gas supply tube 5 in the reaction chamber 6. Consequently, the hard layer is deposited on the surfaces of the cutting tool bodies by chemical vapor deposition.

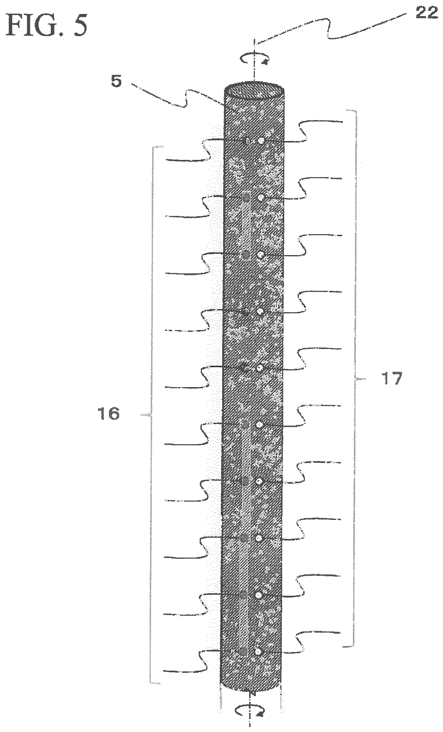

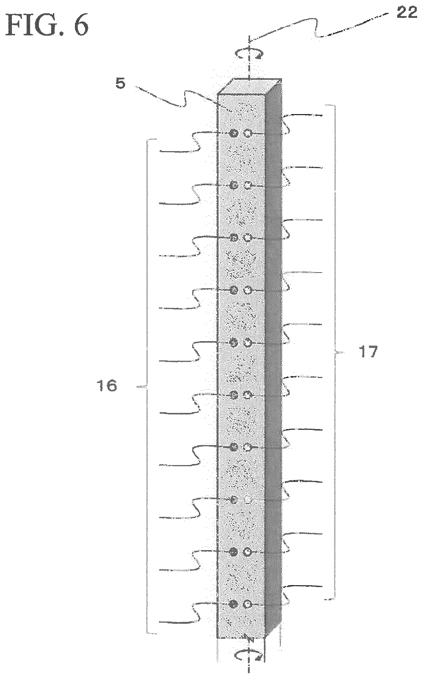

In addition, the ejection port A (16) provided to the section A (14), and the ejection port B (17) provided to the section B (15), are formed at multiple locations in the vertical direction along with the direction of the rotation axis 22 of the gas supply tube 5 as shown in FIGS. 5 and 6.

Gas ejection port provided to the gas supply tube 5 having the rotating mechanism provided in the apparatus:
The gas supply tube 5 having the rotating mechanism provided in the apparatus includes the separated two sections, the section A (14) and the section B (15) as shown in FIGS. 3 and 4.

These gas ejection ports are provided in such a way that the raw material gas group A, which is ejected from the ejection port A (14) provided on the section A (16), and the raw material gas group B, which is ejected from the ejection port B (17) provided on the section B (15), are mixed in the outside of the gas supply tube 5.

The ejection port closest to each of the ejection port A (16) provided on the section A (14) is one of the ejection ports B (17) provided on the section B (15); and the ejection port closest to each of the ejection port B (17) provided on the section B (15) is one of the ejection ports A (16) provided on the section A (14).

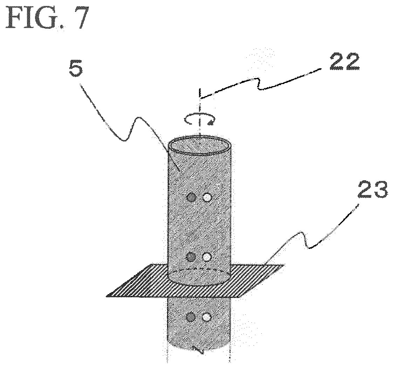

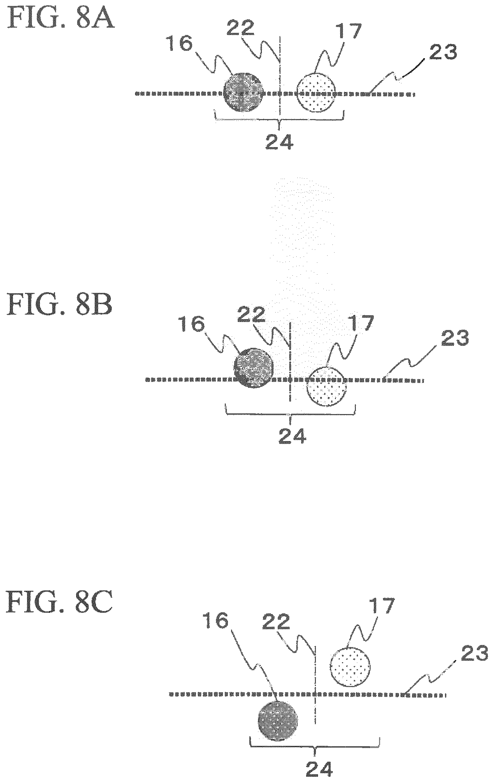

In addition, the ejection port A (16) and the ejection port B (17), each of which is the closest ejection port to the counterpart, form the pair as shown in FIGS. 5 and 6; and ejection ports are provided in such a way that both of the ejection port A (16) and the ejection port B (17) forming the pair 24 intersect the plane 23 having the normal line corresponding to the rotation axis 22 of the gas supply tube 5 as shown in FIGS 7, 8A, 8B, and 8C.

Because of the arrangement of the pair 24 with the ejection port A (16) and the ejection port B (17) as shown in FIGS. 8A and 8B, uniform coating films can be formed over the intended large area in the apparatus even in the case where deposition is performed by using the gas species that are highly reactive each other.

In the case where the ejection port A (16) and the ejection port B (17) are not provided as the pair 24, the raw material gas groups A and B are mixed to react only after being retained in the reaction chamber 6. Therefore, reaction in the gaseous phase is facilitated; and consequently film formation is made by deposition of nuclei formed in the gaseous phase. Accordingly, it is impossible to obtain the uniform coating films over the intended large area in the apparatus.

In addition, even though they form the pair 24, in the case where the ejection port A (16) and the ejection port B (17) are arranged as shown in FIG. 8C, in other words, in the case where parts of the gas ejection port A (16) and the gas ejection port (17), each of which is the ejection port of the separated gases, are not provided in such a way that they intersect the plane 23 having the normal line corresponding to the rotation axis 22 of the rotating gas supply tube 5, it is harder to obtain the mixing effect of the raw material gas groups A and B by the revolving component from the rotation movement of the gas supply tube 5; and it is impossible to obtain uniform coating films over the intended large area in the apparatus.

Moreover, it is preferable that the ejection port A (16) and the ejection port B (17) forming the pair 24 as the closest ejection port each other are provided in such a way that the distance 20 between the ejection ports A and B (20) is 2 mm to 30 mm as shown in FIGS. 3 and 4. More preferably, the distance 20 is 2 mm to 15 mm. Even more preferably, it is 3 mm to 8 mm.

By having the configuration described above, it is possible to obtain coating films having particularly uniform film thickness over the intended large area in the apparatus.

The suitable distance 20 between the ejection ports depends on the reactivity between the raw material gas groups A and B. However, if the distance 20 were too short, thick films would be deposited only on deposition materials near the gas ejection port; and the film thickness of deposition materials far from the gas ejection port becomes thin.

On the other hand, if the distance 20 were too far, the film thickness of deposition materials near the gas ejection port is likely to be thin.

In addition, it is preferable that, in the ejection port A (16) and the ejection port B (17) forming the pair 24 as the closest ejection ports each other as shown in FIGS. 8A and 8B by the reference symbol 24, the ejection ports are provided in such a way that the angle 21, which formed by connecting: the center 18 of the ejection port A (16); the center 13 of the rotation axis of the gas supply tube 5; and the center 19 of the ejection port B (17), after projected on the surface perpendicular to the rotation axis, is 60° or less as shown in FIGS 3 and 4. More preferably, the angle 21 is 40° or less. Even more preferably, it is 20° or less.

Because of the configuration described above, it is possible to obtain the uniform coating films over the intended large area in the apparatus.

The suitable angle 21 depends on the reactivity between the raw material gas groups A and B. However, if the angle 21 were too wide, mixing of gases near the gas ejection port would not proceeded near the gas ejection port; and the film thickness of deposition materials near the gas ejection port is likely to be thin.

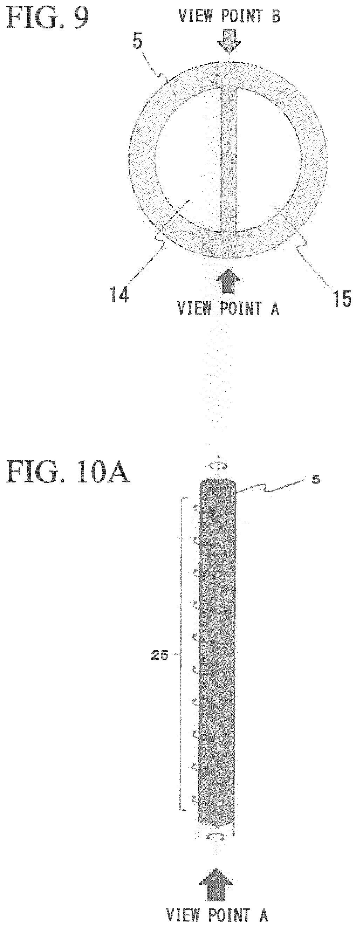

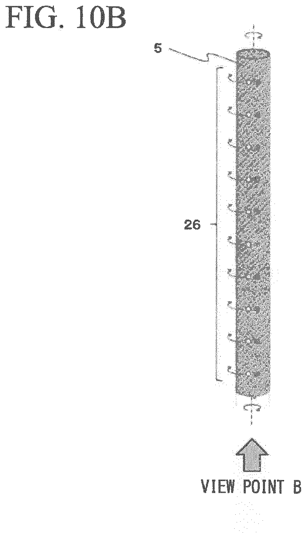

As the ejection ports that are closest each other and form the pair 24 of the ejection port A (16) and the ejection port B (17), the ejection port pair 25, which rotates while the ejection port A (16) precedes in the rotation direction of the gas supply tube 5 as shown in FIG. 10A; and the ejection port pair 26, which rotates while the ejection port B (17) precedes as shown in FIG. 10B, may co-exist. In this case, depending on which gas ejection port precedes, phenomena, in which extents of mixing and reaction between the raw material gas groups A and B differ, occur, even though they also depend on the gas species and the reactivity of the raw material gas groups A and B.

By utilizing these phenomena, coating films having a nano-scaled texture structure, which have been hard to obtain in the conventional chemical vapor deposition apparatus, can be formed.

This is because the coating films are formed from precursors with different qualities. One precursor is the precursor that the ejection port pair 25, which rotates while the ejection port A (16) precedes, contributes primarily on its formation. Another precursor is the precursor the ejection port pair 26, which rotates while the ejection port B (17) precedes, contributes primarily on its formation. Because of this, it becomes possible to form a nanocomposite structure for example. In addition, by the two kinds of precursors being existed, an energetically unstable state is produced on the surfaces of the deposition materials during deposition, which stimulates self-organization by surface diffusion. As a result, it is possible to form stronger coating films as the coating films of cutting tools.

### Rotation speed of the gas supply tube (5):

In chemical vapor deposition by the apparatus, it is preferable that the gas supply tube 5 is rotated at the rotation speed of 10-60 revolutions/minute. More preferably, the rotation speed is 20-60 revolutions/minute. Even more preferably, it is 30-60 revolutions/minute. Because of this configuration, uniform coating films are formed over the intended large area in the apparatus. This is because the raw material gas groups A and B are mixed uniformly by the revolving component from the rotation movement of the gas supply tube 5 during gas ejection from the rotating gas supply tube 5. It also depends on gas species and reactivity of the raw material gas groups A and B.

### Raw material gas:

In chemical vapor deposition by the apparatus, one or more of gases selected from an inorganic raw material gas and an organic raw material gas, which are free of metal elements; and a carrier gas can be used as the raw material gas group A. As the raw material gas group B, one or more of gases selected from an inorganic raw material gas and an organic raw material gas; and a carrier gas can be used. The raw material gas group B includes at least one of metal elements.

For example, in formation of the hard layers on the surfaces of the cutting tool bodies by using the apparatus of the present invention, the chemical vapor deposition is performed by: selecting NH₃ and the carrier gas (H₂) as the raw material gas group A; and selecting TiCl₄ and the carrier gas (H₂) as the raw material gas group B. Because of these, the surface-coated cutting tool (refer Example 1 of the present invention in Table 1), which has excellent layer thickness uniformity of the TiN layer formed over the large area by the chemical vapor deposition, can be produced.

In addition, for example, the chemical vapor deposition is performed by: selecting CH₃CN, N₂ and the carrier gas (H₂) as the raw material gas group A; and selecting TiCl₄, N₂ and the carrier gas (H₂) as the raw material gas group B. Because of these, the surface-coated cutting tool (refer Example 4 of the present invention in Table 1), which has excellent layer thickness uniformity of the TiCN layer formed over the large area by the chemical vapor deposition, can be produced.

In the chemical vapor deposition method, the above-described chemical vapor deposition apparatus is set first. Then, multiple cutting tool bodies are inserted in the reaction chamber 6. The gas composition, pressure, and temperature in the reaction chamber 6 are controlled to an appropriate condition for forming the hard films. The raw material gas group A is supplied in the reaction chamber 6 through the section A, which is the gas passage provided in the gas supply tube 5. The raw material gas group B is supplied in the reaction chamber 6 through the section B, which is the gas passage provided in the gas supply tube 5. In the gas supply tube 5, the partition wall that physically separates the section A and the section B is provided. The gas supply tube 5 makes rotation movement about the axis direction thereof. The rotation direction and the rotation speed of the gas supply tube 5 are appropriately controlled in consideration of the characteristics of the intended hard film to be deposited; the characteristics of the raw material gas group A; and the characteristics of the raw material gas group B. The raw material gas group A is ejected from the ejection port A (16) into the reaction chamber 6. The raw material gas group B is ejected from the ejection port B (17) into the reaction chamber 6. The raw material gas groups A and B ejected into the reaction chamber 6 are mixed outer side of the gas supply tube 5; and the hard films are deposited on the surfaces of the cutting tool bodies by chemical vapor deposition.

### [Second Embodiment]

The second embodiment of the present invention is explained below in reference to drawing.

### [Chemical vapor deposition apparatus]

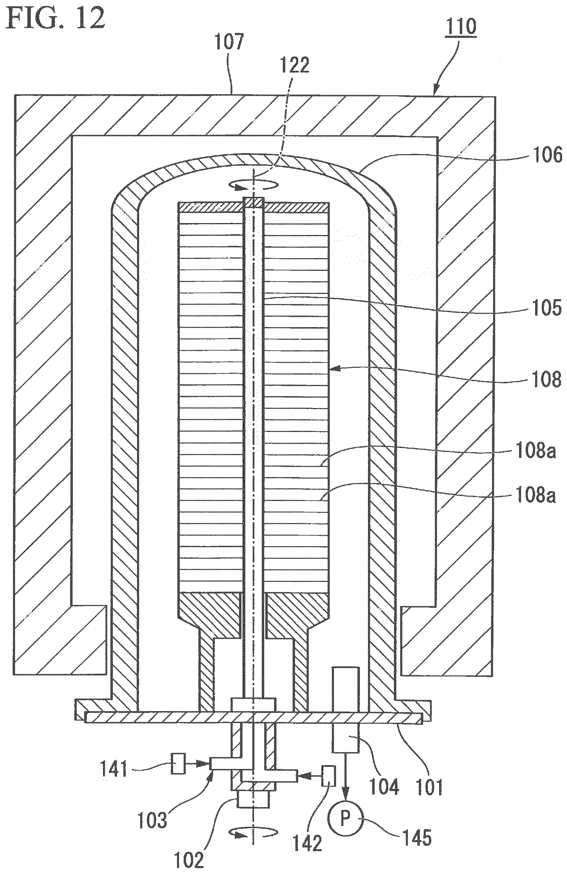

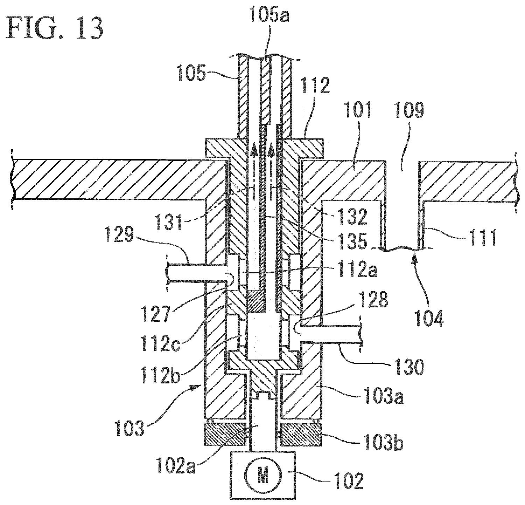

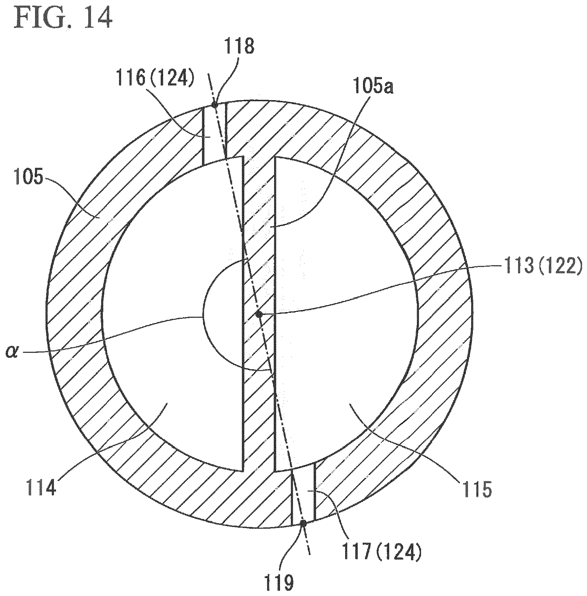

FIG. 12 is a cross-sectional view of the chemical vapor deposition apparatus related to an embodiment of the present invention. FIG. 13 is a cross-sectional view of the gas supply tube and the rotary drive device. FIG. 14 is a horizontal cross-sectional view of the gas supply tube.

The chemical vapor deposition apparatus 110 of the present embodiment is a CVD (Chemical Vapor Deposition) apparatus for forming coating films on the surfaces of the deposition materials by having reaction of multiple raw material gases in a heated atmosphere. The chemical vapor deposition apparatus 110 of the present embodiment can be suitably used for producing the surface-coated cutting tools in which the surfaces of the cutting tool bodies made of cemented carbide are coated by hard layers.

As examples of the cutting tool bodies, WC-based cemented carbide, TiCN-based cermet, Si₃N₄-based ceramics, Al₂O₃-based ceramics, cBN-based ultra-high-pressure sintered material; and the like are named. As examples of the hard layers, AlTiN layer, TiN layer, TiCN layer, and the like are named.

The chemical vapor deposition apparatus 110 of the present embodiment includes: the baseplate 101; the work housing 108 provided above the baseplate 101; the bell-shaped reaction chamber 106 covered on the baseplate 101 enclosing the work housing 108; and the outside thermal heater 107 covered on the side and top surfaces of the reaction chamber as shown in FIG. 12. In the chemical vapor deposition apparatus 110 of the present invention, the connecting part between the baseplate 101 and the reaction chamber 106 is sealed; and the inside space of the reaction chamber 106 can be retained in vacuum atmosphere.

The outside thermal heater 107 heats the inside of the reaction chamber 106 to a predetermined deposition temperature (700°C to 1050°C, for example), and retains the temperature.

The work housing 108 is formed from the multiple trays 108a, on each of which the cutting tool bodies (deposition materials) are placed, stacked in the vertical direction. Each of neighboring trays 108a in the vertical direction is interposed by sufficient space enough for the raw material gases to be flown. All trays 108a of the work housing 108 have the through hole, into which the gas supply tube 105 is inserted, in the middle.

The gas feeding part 103; the gas exhaust part 104; and the gas supply tube 105 are provided to the baseplate 101.

The gas feeding part 103 is provided to pass through the baseplate 101 and supplies the two kinds of materials gas groups, the raw material gas group A (the first gas) and the raw material gas group B (the second gas), to the internal space of the reaction chamber 106. The gas feeding part 103 is connected to the gas supply tube 105 inside of the baseplate 101 (the side of the reaction chamber 106). The gas feeding part 103 includes: the raw material gas group A inlet pipe 129, which is connected to the raw material gas group A source 141, and the raw material gas group B inlet pipe 130, which is connected to the raw material B source 142. The raw material gas group A inlet pipe 129 and the raw material gas group B inlet pipe 130 are connected to the gas supply tube 105. The motor (rotary drive device) 102 rotating the gas supply tube 105 is provided to the gas feeding part 103.

The gas exhaust part 104 is provided to pass through the baseplate 101, and connects the vacuum pump 145 and the internal space of the reaction chamber 106. The content in the reaction chamber 106 is exhausted through the gas exhaust part 104 with the vacuum pump 145.

The gas supply tube 105 is a tubular part extending from the baseplate 101 in the vertical direction. The gas supply tube 105 is provided to pass through the work housing 108 in the middle in the vertical direction. The upper end of the gas supply tube 105 is sealed; and the raw material gas groups are ejected from the side surface of the gas supply tube 105 to the outer side thereof in the present embodiment.

FIG. 13 is a cross-sectional view showing: the baseplate 101; the gas feeding part 103; and the gas exhaust part 104.

The gas exhaust part 104 includes the gas exhaust pipe 111, which is connected to the gas outlet 109 passing through the baseplate 101. The gas exhaust pipe 111 is connected to the vacuum pump 145 shown in FIG 12.

The gas feeding part 103 includes: the supporting part 103a in a cylindrical shape extending toward the outside of the baseplate 101; the rotary gas introduction part 112 housed in the supporting part 103a; the motor 102 connected to the rotary gas introduction part 112 through the coupling 102a; and the sliding part 103b for sealing having the coupling 102a to be slid.

The inside of the supporting part 103a is connected to the inside of the reaction chamber 106. To the supporting part 103a, the raw material gas group A inlet pipe 129 and the raw material gas group B gas inlet pipe 130, both of which pass through the side surface of the supporting part 103a, are provided. The raw material gas group A inlet pipe 129 is provided to the side that is closer than the raw material gas group B inlet pipe 130 to the reaction chamber 106 in the vertical direction. The raw material gas group A inlet pipe 129 includes the raw material gas group A inlet 127 opening at the inner circumferential surface of the supporting part 103a. The raw material gas group B inlet pipe 130 includes the raw material gas group B inlet 128 opening at the inner circumferential surface of the supporting part 103a.

The rotary gas introduction part 112 is in a tubular shape coaxial with the supporting part 103a. The rotary gas introduction part 112 is inserted in the supporting part 103a and rotary driven about the axis of the rotary axis 122 by the motor 102 that is connected to the end part (the lower end part) in the opposite side of the reaction chamber 106.

The through holes 112a, 112b, which pass through the side all of the rotary gas introduction part 112, are provided to the rotary gas introduction part 112. The through hole 112a is provided in the same height position as that of the raw material gas group A inlet 127 of the supporting part 103a. The through hole 112b is provided in the same height position as that of the raw material gas group B inlet 128 of the supporting part 103a. Among the outer peripheral surface of the rotary gas injection part 112, the sealing 112c, which is formed with the diameter larger than other part, is provided between the through hole 112a and the through hole 112b. The sealing 112c abuts to the inner peripheral surface of the supporting part 103 a and separates the raw material gas group A flowing in from the raw material gas group A inlet 127 and the raw material gas group B flowing in from the raw material gas group B inlet 128.

The partition 135 is provided in the inside of the rotary gas injection part 112. The partition 135 sections the inside of the rotary gas introduction part 112 into the raw material gas group A introduction path 131 and the raw material gas group A introduction path 132, both of which extend in the height direction (the axis direction). The raw material gas group A introduction path 131 is connected to the raw material gas group A inlet 127 through the through hole 112a. The raw material gas group B introduction path 132 is connected to the raw material gas group B inlet 128 through the through hole 112b. The gas supply tube 105 is connected to the upper end of the rotary gas introduction part 112.

Configurations of the gas supply tube 105 are explained in detail below.

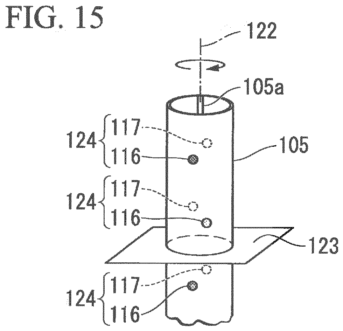

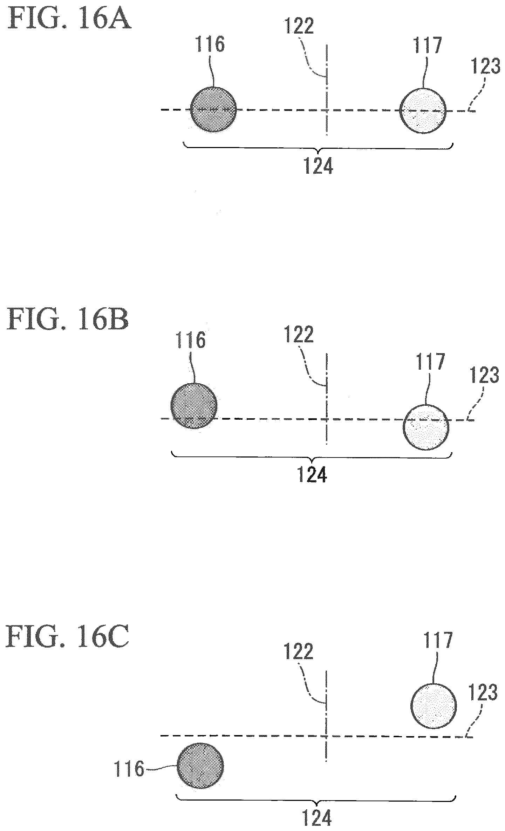

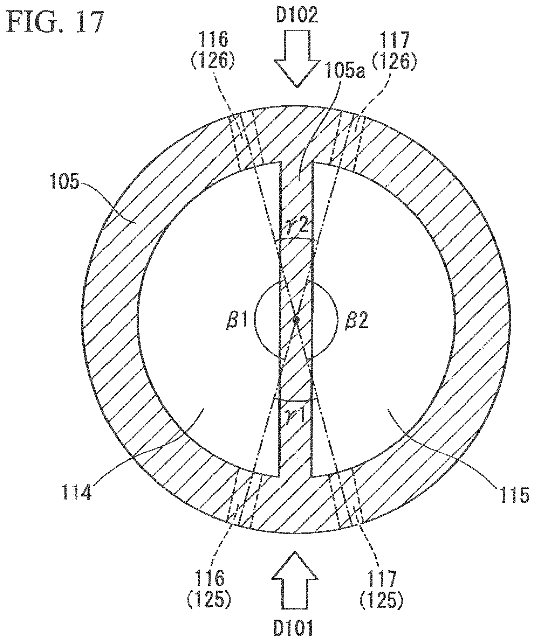

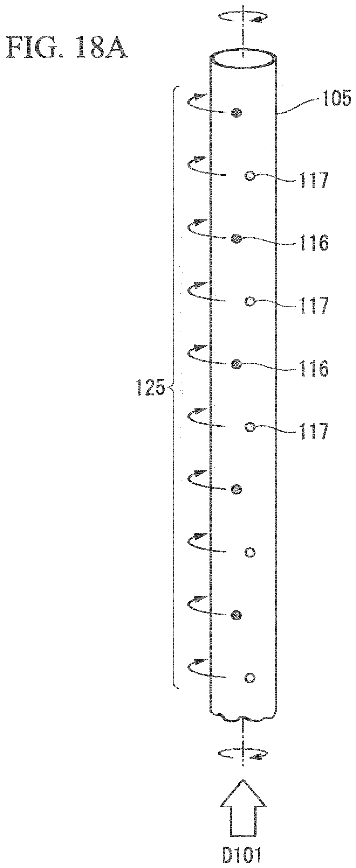

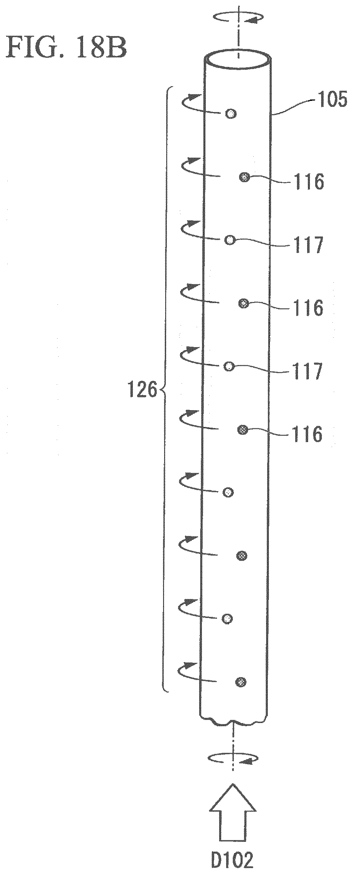

FIG. 14 is a horizontal cross-sectional view of the gas supply tube 105. FIG. 15 is a partial perspective view of the gas supply tube 105. FIGS. 16A to 16C are explanatory diagrams of the arrangement of the gas ejection ports. FIG 17 is a cross-sectional view for explaining the arrangement of the gas ejection ports. FIGS. 18A and 18B are perspective views for explaining the arrangement of the gas ejection ports.

The gas supply tube 105 is a cylindrical tube. In the gas supply tube 105, the partition 105a, which is in the plate form extending in the height direction (the axis direction), is provided. The partition 105a longitudinally traverses the gas supply tube 105 in the diametrical direction in such a way that it includes the central axis (the rotation axis 122) of the gas supply tube 105; and roughly bisects the inside of the gas supply tube 105. The inside of the gas supply tube 105 is sectioned into the raw material gas group A flowing section 114 (the first gas flowing section) and the raw material gas group B flowing section 115 (the second gas flowing section) by the partition 105a. The raw material gas group A flowing section 114 and the raw material gas group B flowing section 115 are extended in the gas supply tube 105 entirely in the height direction.

As shown in FIG 13, the lower end of the partition 105a is connected to the upper end of the partition 135. The raw material gas group A flowing section 114 is connected to the raw material gas group A introduction path 131. The raw material gas group B flowing section 115 is connected to the raw material gas group A introduction path 132. Therefore, the circulation route of the raw material gas group A supplied from the raw material gas group A source 141 and the circulation route of the raw material gas group B supplied from the raw material gas group B source 142 are mutually independent circulation routes sectioned by the partition 135 and the partition 105a.

Multiple raw material gas group A ejection ports 116 (the first gas ejection ports); and multiple raw material gas group B ejection ports 117 (the second gas ejection ports), each of which passes through the side wall of the gas supply tube 105, are provided to the gas supply tube 105 as shown in FIGS. 14 and 15. The raw material gas group A ejection port 116 ejects the raw material gas group A into the internal space of the reaction chamber 106 from the raw material gas group A flowing section 114. The raw material gas group B ejection port 117 ejects the raw material gas group B into the internal space of the reaction chamber 106 from the raw material gas group B flowing section 115. Each of the raw material gas group A ejection port 116 and the raw material gas group B ejection port 117 is provided at multiple locations along with the longitudinal direction (the height direction) of the gas supply tube 105 (refer FIGS 15, 18A, and 18B).

In the gas supply tube 105 in the present embodiment, each one of the raw material gas group A ejection port 116 and the raw material gas group B ejection port 117 is provided at the roughly the same height position as shown in FIGS. 14 and 15. These raw material gas group A ejection port 116 and raw material gas group B ejection port 117 lying next to each other in the peripheral direction form a pair, and construct the ejection port pair 124 as shown in FIG. 15. To the gas supply tube 105, multiple ejection port pairs 124 are provided in the height direction.

In the relationship of the height location between the raw material gas group A ejection port 116 and the raw material gas group B ejection port 117 forming the ejection port pair 124, both of the above-described raw material gas group A ejection port 116 and the raw material gas group B ejection port 117 intersect with a plane 123 with the normal line corresponding to the rotation axis 122 shown in FIG 15. The above-described relationship of the height location is defined as the location relationship "lying next to each other in the peripheral direction" in the description of the present embodiment.

As specific examples, FIGS. 16A and 16B are shown. In the example shown in FIG. 16A, the raw material gas group A ejection port 116 and the raw material gas group B ejection port 117 forming the ejection port pair 124 are placed at the same height location. In the example shown in FIG. 16B, a part of the raw material gas group A ejection port 116 and a part of the raw material gas group B ejection port 117 are placed at the same height location. In the examples shown in FIGS. 16A and 16B, it is regarded that the location relationship "lying next to each other in the peripheral direction" is satisfied in these ejection ports. On the other hand, in the example shown in FIG. 16C, the location relationship "lying next to each other in the peripheral direction" is not satisfied in these ejection ports. In the example shown in FIG 16C, the entire raw material gas group A ejection port 116 is provided at the different height location to the entire raw material gas group B ejection port 117.

The raw material gas group A ejection port 116 and the raw material gas group B ejection port 117 shown in FIG. 14 are the ejection ports belonging to the same ejection port pair 124. In the configuration shown in FIG. 15, the relative angle α between raw material gas group A ejection port 116 and the raw material gas group B ejection port 117 about the axis is 180°. The relative angle α can be changed in the range of 150° or more and 180° or less.

The relative angle α is defined as the angle formed by the center 118 of the outer edge of the opening of the raw material gas group A ejection port 116 and the center 119 of the outer edge of the opening of the raw material gas group B ejection port 117 about the axis centered by the center 113 of the gas supply tube 105 (the rotation axis 122) in the present embodiment. Since the relative angle α is the angle about the axis, in the case where the locations in the height direction differs between the center 118 and the center 119, the angle is obtained by projecting the centers 118 and 119 on a plane perpendicular to the rotation axis 122.

As shown in FIGS. 18A and 18B, the raw material gas group A ejection port 116 and the raw material gas group B ejection port 117 are alternatingly aligned in the state where they are close in the height direction (the axis direction) of the gas supply tube 105. In the present embodiment, it is preferable that the raw material gas group A ejection ports 116, which connect to the raw material gas group A flowing section 114, are provided in 2 different angular positions in the peripheral direction of the gas supply tube 105 as shown in FIG. 17. In addition, it is preferable that the raw material gas group B ejection ports 117, which connect to the raw material gas group B flowing section 115, are provided in 2 different angular positions in the peripheral direction of the gas supply tube 105. Alternatively, in terms of the raw material gas group A ejection ports 116, which connect to the raw material gas group A flowing section 114; and the raw material gas group B ejection ports 117, which connect to the raw material gas group B flowing section 115, they may be provided at a single angular location in the height direction (the axis direction); or they may be provided at three angular locations in the height direction (the axis direction).

It is preferable that the relative angle β1 between the raw material gas group A ejection ports 116 on 2 locations about the axis shown in FIG. 17 is 130° or more. In addition, it is preferable that the relative angle β2 between the raw material gas group B ejection ports 117 on 2 locations about the axis is 130° or more.

Because of the configurations described above, the gas supply tube 105 includes the ejection port group 125 (FIG. 18A), which is provided on the D101 side, and the ejection port group 126 (FIG. 18B), which is provided on the D102 side, shown in FIG. 17. In any one of the ejection port group 125 and the ejection port group 126, the raw material gas group A ejection port 116 and the raw material gas group B ejection port 117 are alternatingly arranged in the height direction of the gas supply tube 105.

It is preferable that, in the ejection port group 125, the relative angle γ1 of the neighboring raw material gas group A ejection port 116 and the raw material gas group B ejection port 117 in the axis direction about the axis is 60° or less. In addition, it is preferable that, in the ejection port group 126, the relative angle γ2 of the neighboring raw material gas group A ejection port 116 and the raw material gas group B ejection port 117 in the axis direction about the axis is 60° or less.

### [Chemical vapor deposition method]

In the chemical vapor deposition method using the chemical vapor deposition apparatus 110, the raw material gas group A and the raw material gas group B are supplied to the gas feeding part 103 from the raw material gas group A source 141 and the raw material gas group B source 142, respectively, while the gas supply tube 105 is rotated about the axis of the rotation axis 122 with the motor 102.

It is preferable that the rotation speed of the gas supply tube 105 is 10 revolutions/minute or more and 60 revolutions/minute or less. More preferably, the rotation speed of the gas supply tube 105 is 20 revolutions/minute or more and 60 revolutions/minute or less. Even more preferably, it is 30 revolutions/minute or more and 60 revolutions/minute or less. Because of this configuration, uniform coating films can be formed over the intended large area in the reaction chamber 106. This is because each of the raw material gas group A and the raw material gas group B are stirred and uniformly dispersed due to the revolving component of the rotation movement of the gas supply tube 105 during ejection of the raw material gas groups from the rotating gas supply tube 105. The rotation speed of the gas supply tube 105 is controlled depending on the kinds of gas types and/or reactivity of the raw material gas groups A and B. If the rotation speed exceeded 60 revolutions/minute, the raw material gases would be mixed in the space too close to the gas supply tube 105, which is likely to cause a problem such as occlusion of the ejection ports.

As the raw material gas group A, one or more of gases selected from an inorganic raw material gas and an organic raw material gas, which are free of metal elements; and a carrier gas can be used. As the raw material gas group B, one or more of gases selected from an inorganic raw material gas and an organic raw material gas; and a carrier gas can be used. The raw material gas group B includes at least one of metal elements.

For example, in formation of the hard layers on the surfaces of the cutting tool bodies by using the chemical vapor deposition apparatus 110, the chemical vapor deposition is performed by: selecting NH₃ and the carrier gas (H₂) as the raw material gas group A; and selecting TiCl₄ and the carrier gas (H₂) as the raw material gas group B. Because of these, the surface-coated cutting tool having the hard layer of the TiN layer can be produced.

In addition, for example, the chemical vapor deposition is performed by: selecting CH₃CN, N₂ and the carrier gas (H₂) as the raw material gas group A; and selecting TiCl₄, N₂ and the carrier gas (H₂) as the raw material gas group B. Because of these, the surface-coated cutting tool with the hard layer of the TiCN layer can be produced.

In addition, for example, the chemical vapor deposition is performed by: selecting NH₃ and the carrier gas (H₂) as the raw material gas group A; and selecting TiCl₄, AlCl₃, N₂ and the carrier gas (H₂) as the raw material gas group B. Because of these, the surface-coated cutting tool with the hard layer of the AlTiN layer can be produced.

The raw material gas group A supplied from the raw material gas group A source 141 is ejected to the internal space of the reaction chamber 106 from the raw material gas group A ejection port 116 through: the raw material gas group A introduction pipe 129; the raw material gas group A inlet 127; the raw material gas group A introduction path 131; and the raw material gas group A flowing section 114. In addition, The raw material gas group B supplied from the raw material gas group B source 142 is ejected to the internal space of the reaction chamber 106 from the raw material gas group B ejection port 117 through: the raw material gas group B introduction pipe 130; the raw material gas group B inlet 128; the raw material gas group B introduction path 132; and the raw material gas group B flowing section 115. The raw material gas groups A and B ejected from the gas supply tube 105 are mixed in the outer side from the gas supply tube 105 in the reaction chamber 106; and the hard layers are deposited on the surfaces of the cutting tool bodies on the tray 108a by chemical vapor deposition.

In the chemical vapor deposition apparatus 110 of the present embodiment, progress of mixing of gases and the travel time of the gases to the surfaces of the cutting tool bodies can be controlled by configuring that the raw material gas groups A and B are mixed in the inside of the reaction chamber 106 after ejecting them from the rotating gas supply tube 105, while the raw material gas groups A and B are kept being separated in the gas supply tube 105 without mixing. Because of this, occlusion of the inside of the gas supply tube 105 by reaction products; and occlusion of the ejection port by deposition of the coating film components, can be suppressed.

The concentrations of the raw material gas groups A and B ejected from the gas supply tube 105 are relatively high near the gas supply tube 105; and the raw material gas groups A and B are diffused into a uniform concentration as they move away from the gas supply tube 105 in the radial direction. Thus, the quality of the film of the hard layer (the coating film), which is formed when the raw material gas groups A and B are mixed near the gas supply tube 105, differs from a film quality of the hard layer, which is formed when the gases are mixed in a location far from the gas supply tube 105. In such a situation, the hard layers with a uniform film quality cannot be obtained over the intended large area.

Thus, in the chemical vapor deposition apparatus 110 of the present embodiment, the relative angle α between the raw material gas group A ejection port 116 and the raw material gas group B ejection port 117 lying next to each other in the peripheral direction of the gas supply tube 105 about the axis is set to 150° or more. By having the configuration described above, the raw material gas groups A and B are ejected to roughly opposite directions each other in the radial direction of the gas supply tube 105. Because of this, the raw material gas groups A and B are not mixed immediately after ejection; and mixed after uniform diffusion of each of the raw material gas groups A and B in the radial direction of the gas supply tube 105. As a result, uniform reaction occurs in the radial direction in the reaction chamber 106; and the hard layers with a uniform film quality can be formed on the multiple cutting tool bodies placed on the trays 108a.

The uniformity of the film quality of the hard layers also depends on the reactivity of the raw material gas groups A and B. In the present embodiment, the contacting length of the raw material gas groups A and B can be controlled by controlling the rotation speed of the gas supply tube 105. Therefore, by controlling the rotation speed of the gas supply tube 105 depending on the kinds of the raw material gas groups, uniformity of the film quality can be improved further.

In addition, the ejection port pair 124, which is formed by two ejection ports lying next to each other in the peripheral direction, is provided at multiple locations along with the height direction (the axis direction) of the gas supply tube 105 as shown in FIG. 15 in the chemical vapor deposition apparatus 110 of the present embodiment. Because of this, each of the raw material gas groups A and B is uniformly diffused in the radial direction free of retention, and they are mixed in the each level of the work housing 108 (tray 108a). Thus, uniform hard layers can be formed in the large area on the tray 108a.

In addition, the chemical vapor deposition apparatus 110 includes the ejection port group 125 and the ejection port group 126, in both of which the raw material gas group A ejection port 116 and the raw material gas group B ejection port 117 are alternatingly aligned in the height direction, on the side surfaces D101 and D102 of the gas supply tube 105 as shown in FIGS. 17, 18A, and 18B. By having the configuration described above, the raw material gas groups A and B are ejected in the relatively close location in the height direction on both sides of the side surfaces D101 and D102. Thus, retention of the raw material gas groups A and B in the separated state each other can be suppressed and uniformity of the film quality can be improved. Thus, the above-described configuration is more preferable.

Alternatively, in terms of the raw material gas group A ejection ports 116, which connect to the raw material gas group A flowing section 114; and the raw material gas group B ejection ports 117, which connect to the raw material gas group B flowing section 115, they may be provided at a single angular location in the height direction (the axis direction); or they may be provided at three angular locations in the height direction (the axis direction).

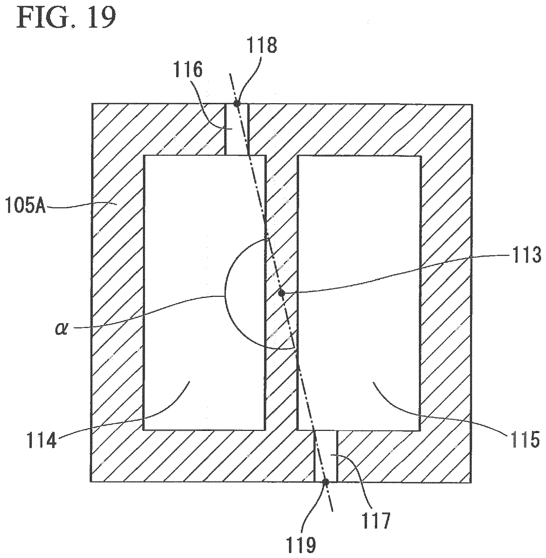

In the present embodiment, the case in which the gas supply tube 105 is a cylindrical tube is explained. However, the gas supply tube 105A, which is made of the polygonal tube having the rectangular shape in the horizontal cross section as shown in FIG. 19, may be used. Furthermore, the shape in the horizontal cross section is not limited to the rectangular shape, and a gas supply tube, which is made of a polygonal tube having the hexagonal or octagonal shape in the horizontal cross section, may be used.

### [First Example]

In the examples, the vertical-vacuum chemical vapor deposition apparatus (hereinafter, referred as "the apparatus of the present Example"), which includes the bell-shaped reaction chamber 6 and the outside thermal heater 7, shown in FIG. 1 was used.

The bell-shaped reaction chamber 6 had the dimension of: 250 mm of the diameter; and 750 mm of the height. The outside thermal heater 7 had the capability of heating the inside of the reaction chamber 6 to about 700°C to 1050°C. In addition, the apparatus of the present Example included at least: the baseplate 1, the rotary gas introduction part 12; the raw material gas group A inlet 27; the raw material gas group B inlet 28; the raw material gas group A inlet introduction path 31; the raw material gas group B inlet introduction path 32 shown in FIG. 11. In addition, the apparatus of the present Example included: the gas supply tube 5; the section A (14); the section B (15), the ejection port A (16); and the ejection port B (17) shown in FIGS. 3, 5, 7, and 8A.

In the apparatus of the present Example, the distance 20 between the centers of the ejection ports A and B forming the pair shown in FIG. 3 was set in the range of 2 mm to 30 mm. In addition, the angle 21 was set in the range equaled to or less than 60°. The angle 21 was obtained by projecting the angle formed by connecting: the center 18 of the ejection port A; the center 13 of the rotation axis of the gas supply tube 5; and the center 19 of the ejection port B shown in FIG. 3 on the plane perpendicular to the rotation axis.

In the apparatus of the present Example, jigs in a donut shape, which had the central hole the gas supply tube 5 could pass through in their central parts, were arranged in the bell-shaped reaction chamber 6. The diameter of the central hole was 65 mm, and the outer diameter of the jigs was 220 mm. WC-based cemented carbide bodies having the shape of CNMG120408 in JIS standard (80° diamond shape having: 4.76 mm of the thickness; and 12.7 mm of the inscribed circle diameter) were placed on the jigs as the deposition materials.

The deposition materials made of WC-based cemented carbide were placed along with the radial direction of the jigs with the interval of 20 mm to 30 mm. At the same time, they were placed along with the circumferential direction of the jigs with the almost identical interval.

By using the apparatus of the present Example, each of the raw material gas groups A and B was introduced from the raw material gas group A inlet 28 into the section A (14); and from the raw material gas group B inlet 29 into the section B (15), respectively, at predetermined flow rates when the gas supply tube 5 with the section A (14) and the section B (15) was rotating at a predetermined rotation speed. Then, by ejecting each of the raw material gas groups A and B from the ejection port A (16) and the ejection port B (17), respectively, the hard coating films of Examples 1 to 10 were formed on the surfaces of the deposition materials made of WC-based cemented carbide by chemical vapor deposition.

The components and compositions of the raw material gas groups A and B used in the chemical vapor deposition are shown in Table 1.

The conditions for chemical vapor deposition in Examples 1 to 10 are shown in Table 2.

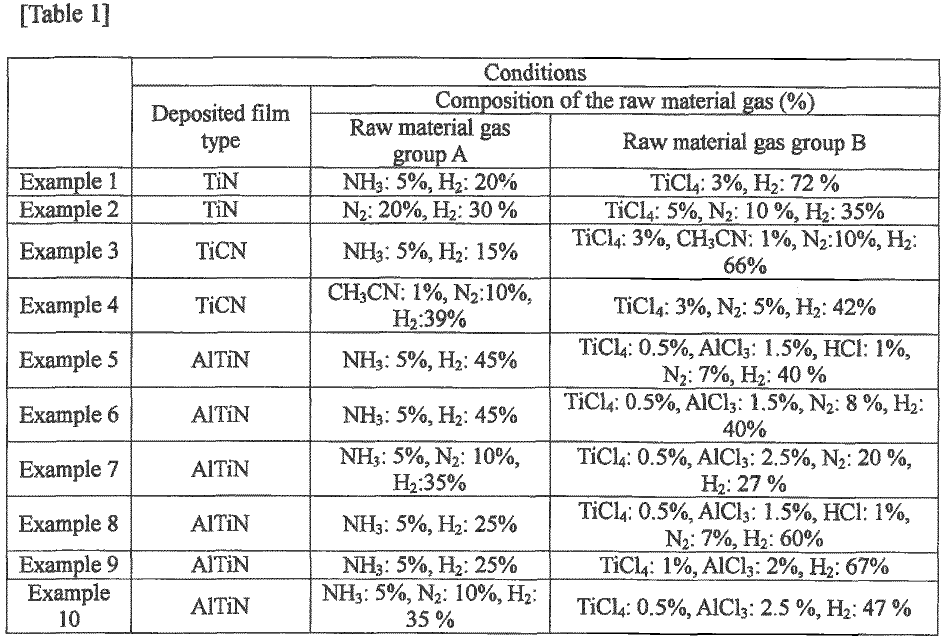

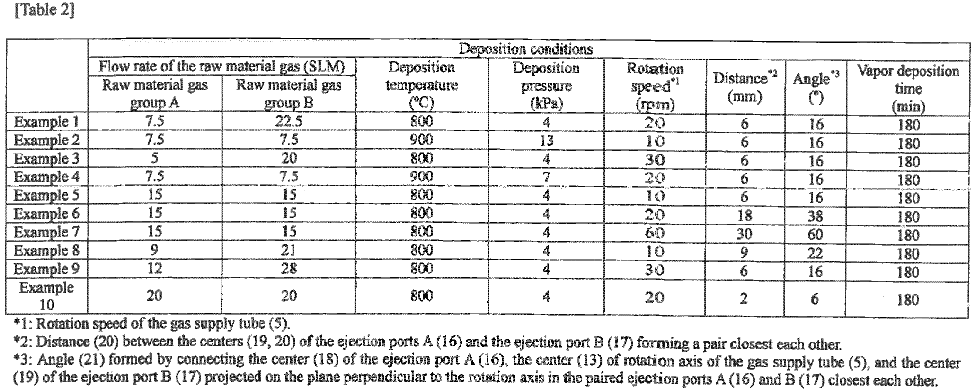

Uniformity of the deposited hard coating films was analyzed in the above-described Examples 1 to 10.

First, the film thickness of the hard coating film deposited on WC-based cemented carbide body was measured on WC-based cemented carbide bodies placed on 10 different positions on the inner circumferential side near the central hole of the donut-shaped jig by observing the cross section perpendicular to the surface of the body with a scanning electron microscope (magnification: 5000 times). Then, the average value was obtained as "the average film thickness T1 of films formed on bodies on the inner circumferential side of the jig."

Then, the thickness of the hard coating film deposited on WC-based cemented carbide body was measured on WC-based cemented carbide bodies placed on 10 different positions on the outer circumferential side of the donut-shaped jig in the same manner as described above. Then, the average value was obtained as "the average film thickness T2 of films formed on bodies on the outer circumferential side of the jig."

Next, the difference between "the average film thickness T1 of films formed on bodies on the inner circumferential side of the jig" and "the average film thickness T2 of films formed on bodies on the outer circumferential side of the jig" was obtained as "the difference of the average film thicknesses at the inner and outer circumferential sides |T1-T2|." In addition, "the ratio of the difference of the average film thickness at the inner and outer sides (|T1-T2|)×100/T1" was obtained.

The obtained values are shown in Table 3.

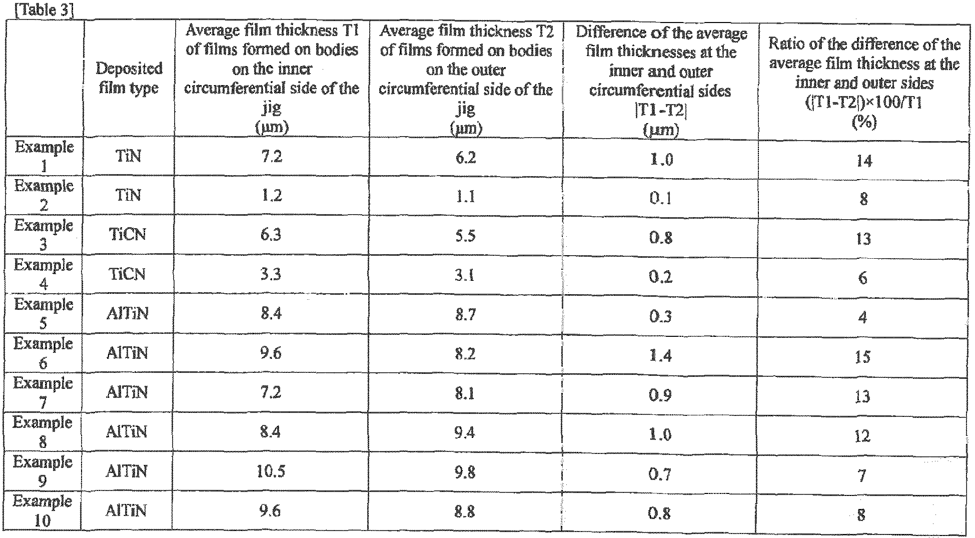

Based on the results shown in Table 3, it was demonstrated that according to the chemical vapor deposition method using the vertical-vacuum chemical vapor deposition apparatus, even if gases highly reactively each other were included as raw material gases, the coating films having a high uniformity in terms of the film thickness were formed, regardless of the placement location of the body on the jig arranged in the apparatus, since "the ratio of the difference of the average film thickness at the inner and outer sides (|T1-T2|)×100/T1" was 15% or less and the difference of the average film thicknesses was extremely low.

Especially, it was possible to deposit the TiN coating film, the TiCN coating film, and the AlTiN coating film, each of which was the deposition coating film type, over the large area in the apparatus with a high uniformity, even though ammonia gas (NH₃) was included in the raw material gas group A that was highly reactive to the metal chloride gases (TiCl₄, AlCl₃, and the like) of the raw material gas group B in Examples 1, 3, and 5-10.

In the conventional chemical vapor deposition apparatus and the conventional chemical vapor deposition method, in the case where these gas species that are highly reactive each other as in the above-described raw material gases, the chemical reaction proceeds in the gas supply tube; and reactants are deposited thickly on the inside of the gas supply tube. In addition, depositions occur in the vicinity of the gas ejection port, which causes a problem of occlusion of the gas supply tube. According to the chemical vapor deposition apparatus and the chemical vapor deposition occurrence of these problems was prevented.

In addition, in deposition using the gas species that had not high reactivity each other as the raw material gases as shown in Examples 2 and 4, according to the vertical-vacuum chemical vapor deposition apparatus and the chemical vapor deposition method more uniform deposition over the large deposition area in the apparatus was possible by setting the optimum deposition condition.

### [Second Example]

In Second Example, the chemical vapor deposition apparatus, which is described as the aspect (6) of the present invention, was evaluated.

The chemical vapor deposition apparatus, which is described as the aspect (6) of the present invention, included: the reaction chamber housing the deposition materials; the gas supply tube provided in the reaction chamber; and the rotary drive device rotating the gas supply tube about the rotation axis in the reaction chamber. The inside of the gas supply tube was sectioned into the first gas flowing section and the second gas flowing section, both of which were extending along with the rotation axis. On the tube wall of the gas supply tube, the first gas ejection port, which ejected the first gas circulating in the first gas flowing section into the reaction chamber, and the second gas ejection port, which ejected the second gas circulating in the second gas flowing section into the reaction chamber, were provided lying next each other in the circumferential direction of the rotation axis. In the plane having the normal line corresponding to the rotation axis, the first gas ejection port and the second ejection port formed a pair. The relative angle of the first and second ejection ports about the rotation axis was 150° or more and 180° or less in the plane having the normal line corresponding to the rotation axis.

In the present Example, the chemical vapor deposition apparatus 110, which was explained as the embodiment in reference to FIGS. 12-19, was used (hereinafter, referred as "the apparatus of the present Example"). The bell-shaped reaction chamber 106 had the dimension of: 250 mm of the diameter; and 750 mm of height. As the outside thermal heater 107, the heater capable of heating the inside of the reaction chamber 106 to 700°C to 1050°C was used. As tray 108a, the ring-shaped jigs were used. The jig had the central hole having 65 mm of the diameter in the middle; and 220 mm of the outer diameter.

WC-based cemented carbide bodies having the shape of CNMG120408 in JIS standard (80° diamond shape having: 4.76 mm of the thickness; and 12.7 mm of the inscribed circle diameter) were placed on the jig (the tray 108a) as deposition materials.

The deposition materials made of WC-based cemented carbide bodies were placed along with the radial direction of the jig (the tray 108a) with the interval of 20 mm to 30 mm. At the same time, they were placed along with the circumferential direction of the jigs with the almost identical interval.

By using the apparatus of the present Example, each of the raw material gas groups A and B was supplied to the gas supply tube 105 at predetermined flow rates; and the raw material gas groups A and B were ejected into the reaction chamber 106 while the gas supply tube 105 was rotated. Because of this, the hard layers (hard coating films) of Examples 101 to 114 and Comparative Examples 105 to 108 were formed on the surfaces of the deposition materials made of WC-based cemented carbide bodies by chemical vapor deposition.

Among Examples 101 to 114, Examples 111 to 114 correspond to Comparative Examples 101 to 114 for the chemical vapor deposition apparatus of the aspect (6) of the present invention.

The components and compositions of the raw material gas groups A and B used in the chemical vapor deposition are shown in Table 4.

The conditions for chemical vapor deposition in Examples 101 to 114 and Comparative Examples 105 to 108 are shown in Table 5.

The relative angle α in Table 5 is the relative angle between the raw material gas group A ejection port 116 and the raw material gas group B ejection port 117 belonging to an identical ejection port pair 124 about the rotation axis.

The relative angle β1 is the relative angle between the raw material gas group A ejection ports 116 belonging to two ejection port pairs 124 adjacent in the height direction. The relative angle β2 is the relative angle between the raw material gas group B ejection ports 117 belonging to two ejection port pairs 124 adjacent in the height direction.

The relative angle γ1 is the relative angle between the raw material gas group A ejection port 116 and the raw material gas group B ejection port 117 adjacent in the height direction on the one side surface (the side surface D101) of the gas supply tube 105 about the rotation axis. The relative angle γ2 is the relative angle between the raw material gas group A ejection port 116 and the raw material gas group B ejection port 117 adjacent in the height direction on the other side surface (the side surface D102) of the gas supply tube 105 about the rotation axis.

The unit "SLM" shown in Table 5 indicates the standard flow rate L/min (Standard). The standard flow rate is the volumetric flow rate per 1 minute after being converted to 20°C and 1 atm. The unit "rpm" shown Table 2 indicates the number of rotation per 1 minute, and means the rotation speed of the gas supply tube 105.

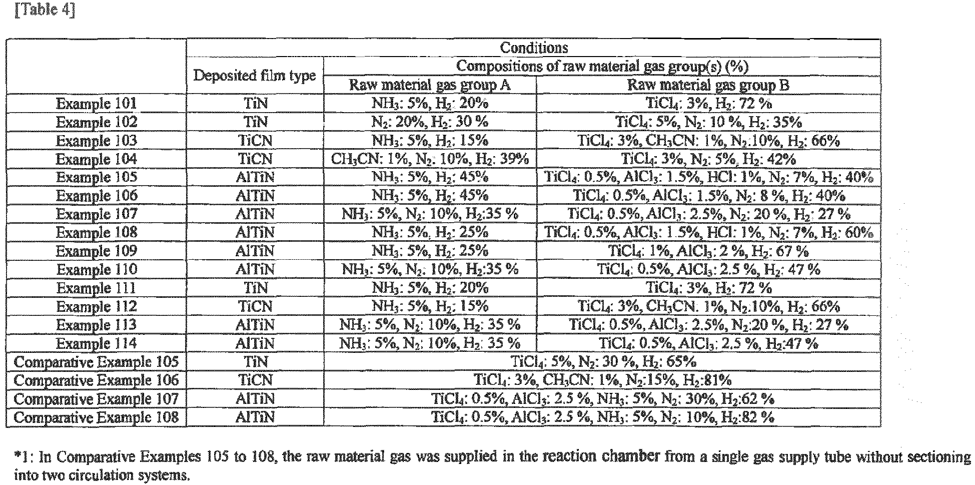

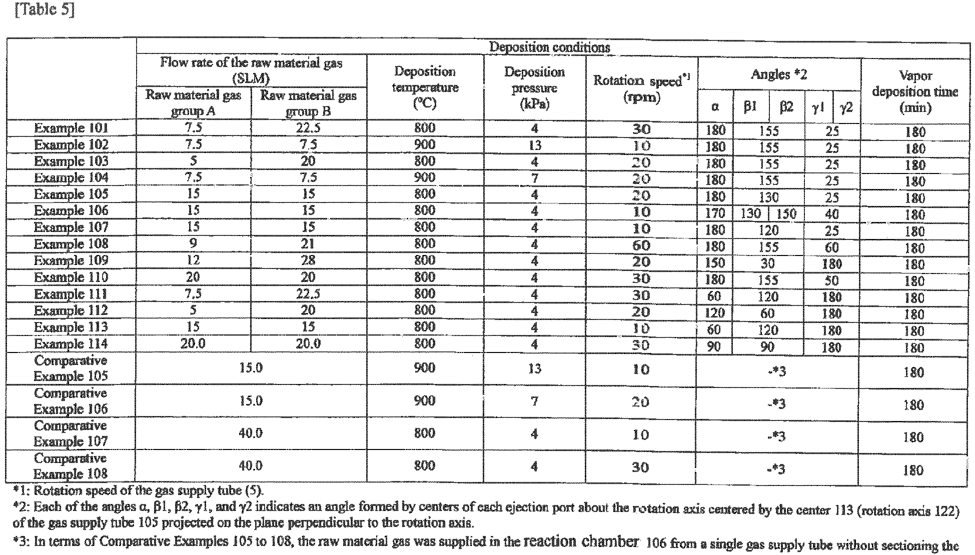

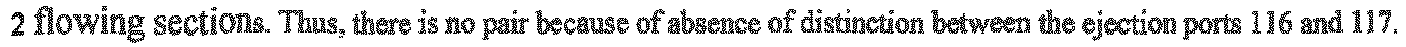

Uniformity of the deposited hard coating films was analyzed in each sample of Examples 101 to 114 and Comparative Examples 105 to 108. In each condition, the residual chlorine amount in the hard coating film deposited on the surface was measured on WC-based cemented carbide bodies placed on 10 different positions on the inner circumferential side near the central hole of the ring-shaped jig (the tray 108a) by the electron micro analyzer (EPMA, Electron-Probe-Micro-Analyser). Then, the average value was obtained as "the average residual chlorine amount of coating films formed on bodies on the inner circumferential side of the jig." In addition, the residual chlorine amount in the hard coating film deposited on the surface was measured on WC-based cemented carbide bodies placed on 10 different positions on the outer circumferential side of the ring-shaped jig (the tray 108a) as described above. Then, the average value was obtained as "the average residual chlorine amount of coating films formed on bodies on the outer circumferential side of the jig." Further, the difference between "the average residual chlorine amount of coating films formed on bodies on the inner circumferential side of the jig" and "the average residual chlorine amount of coating films formed on bodies on the outer circumferential side of the jig" was obtained as "the difference of the residual chlorine amounts at the inner and outer circumferential sides." Each of the above-described obtained values is shown in Table 6.

There is a correlation between the residual chlorine amount measured in the present Examples and the film quality of the hard coating film; and the lesser the residual chlorine amount, the better the film quality. Thus, it is interpreted that having lesser difference of the residual chlorine amounts between on the inner and outer circumference sides means having lesser film quality difference between the inner and outer circumferential sides.

In the present Example, when the raw material gas group A containing the NH₃ gas was used, the hard coating films were formed at a lower temperature due to high reactivity of the gas. However, the hard coating films formed by using the raw material gas group A containing the NH₃ gas is inferior to ones formed by using the raw material gas group A free of NH₃ gas in terms of the film quality; and there is the predisposition for the residual chlorine amount to be increased. Thus, the residual chlorine amount, which is shown in Table 6, being high or low corresponds to inferiority or superiority of the film quality of the hard coating films. In addition, the extent of the residual chlorine amount different between bodies corresponds to the extent of relative difference of the film qualities between the hard coating films.

In addition, EPMA analysis was performed on the AlTiN coating films of Examples 105 to 110, Example 113 (Comparative Example 103), Example 114 (Comparative Example 104), Comparative Example 107, and Comparative Example 108; and Al content (in atomic ratio) relative to the total amount of Al and Ti in the coating film was derived. The analysis results are shown in Table 7.

**[Table 6]**

| | Deposited film type | Residual chlorine amount of coating films formed on bodies on the inner circumferential side of the jig (atomic%) | Residual chlorine amount of coating films formed on bodies on the outer circumferential side of the jig (atomic%) | Difference of the residual chlorine amounts at the inner and outer circumferential sides (atomic%) |
|---|---|---|---|---|
| Example 101 | TiN | 0.11 | 0.09 | 0.01 |
| Example 102 | TiN | 0.02 | 0.03 | 0.01 |
| Example 111 | TiN | 0.18 | 0.10 | 0.08 |
| Comparative Example 105 | TiN | 0.05 | 0.02 | 0.03 |
| Example 103 | TiCN | 0.14 | 0.12 | 0.02 |
| Example 104 | TiCN | 0.02 | 0.01 | 0.01 |
| Example 112 | TiCN | 0.20 | 0.11 | 0.09 |
| Comparative Example 106 | TiCN | 0.04 | 0.01 | 0.03 |
| Example 105 | AlTiN | 0.50 | 0.47 | 0.03 |
| Example 106 | AlTiN | 0.40 | 0.38 | 0.02 |
| Example 107 | AlTiN | 0.23 | 0.19 | 0.04 |
| Example 108 | AlTiN | 0.22 | 0.20 | 0.02 |
| Example 109 | AlTiN | 0.11 | 0.09 | 0.02 |
| Example 110 | AlTiN | 0.09 | 0.09 | 0.00 |
| Example 113 | AlTiN | 0.51 | 0.20 | 0.31 |
| Example 114 | AlTiN | 0.28 | 0.09 | 0.19 |
| Comparative Example 107 | AlTiN | 1.68 | 1.20 | 0.48 |
| Comparative Example 108 | AlTiN | 1.12 | 0.75 | 0.37 |

**[Table 7]**

| | Deposited film type | Average Al content relative to the total content of Al and Ti of coating films formed on bodies on the inner circumferential side of the jigs obtained by EPMA analysis (atomic ratio) Al/Al+Ti (atomic%) | Average Al content relative to the total content of Al and Ti of coating films formed on bodies on the outer circumferential side of the jigs obtained by EPMA analysis (atomic ratio) Al/Al+Ti (atomic%) |
|---|---|---|---|
| Example 105 | AlTiN | 0.84 | 0.83 |
| Example 106 | AlTiN | 0.81 | 0.80 |
| Example 107 | AlTiN | 0.89 | 0.87 |
| Example 108 | AlTiN | 0.85 | 0.84 |
| Example 109 | AlTiN | 0.76 | 0.75 |
| Example 110 | AlTiN | 0.91 | 0.91 |
| Example 113 | AlTiN | 0.87 | 0.80 |
| Example 114 | AlTiN | 0.86 | 0.81 |
| Comparative Example 107 | AlTiN | 0.78 | 0.28 |
| Comparative Example 108 | AlTiN | 0.83 | 0.21 |

Based on the results shown in Table 6, in Examples 101 to 110, in which the relative angle α between the raw material gas group A ejection port 116 and the raw material gas group B ejection port 117 belonging to the identical ejection port pair 124 about the rotation axis was 150° or more, "the difference of the residual chlorine amounts at the inner and outer circumferential sides" was less than 0.04 atomic% and extremely low, even though the gas species that were highly reactive each other were used as the raw material gas groups. Therefore, formation of hard coating films having uniform film quality was confirmed regardless of the placement the location of the body on the jig (the tray 108a) arranged in the reaction chamber 106. In addition, based on the results shown in Table 7, it was demonstrated that in Examples 105 to 110, there were almost no difference of the average Al content relative to the total amount of Al and Ti between the inner and outer circumference sides; and the AlTiN coating films having uniform film quality were formed.

Especially, it was possible to deposit the TiN coating film, the TiCN coating film, and the AlTiN coating film over the large area on the jigs with a highly uniform film quality, even though ammonia gas (NH₃) was included in the raw material gas group A that was highly reactive to the metal chloride gases (TiCl₄, AlCl₃, and the like) of the raw material gas group B in Examples 101, 103, 105 to 110.

In addition, in deposition using the gas species that had not high reactivity each other as the raw material gases as shown in Examples 102 and 104, it was possible to form coating films with a highly uniform film quality over the large area on the jigs by setting the optimum deposition condition in each case.

On the other hand, in Examples 111 to 114 (Comparative Examples 101 to 104), in which the relative angle α was set to narrow angles, 60° or 120°, "the difference of the residual chlorine amounts at the inner and outer circumferential sides" was relatively larger compared to Examples 101 to 110 based on the results shown in Table 6. Similarly, the difference of the average Al contents relative to the total contents of Al and Ti was large compared to Examples 101 to 110 in the results shown in Table 7. Based on these results, it was confirmed that uniformity of the film quality in terms of the composition in Examples 111 to 114 (Comparative Examples 101 to 104) was inferior to that in Examples 101 to 110.

In Comparative Examples 105 to 108, in which the flowing sections of the raw material gas groups A and B were not separated, the coating film components were deposited on the ejection ports; and occlusion of the gas supply tube occurred, although some of them were in a good condition for uniformity of the film quality. In addition, as shown in Table 7, the difference of the average Al content relative to the total amounts of Al and Ti was significantly large compared to Examples of the present invention, confirming variations of the compositions of the AlTiN coating films.

In addition, based on the results in Examples 101 to 106, 108, and 110 shown in Tables 6 and 7, it was demonstrated that it was possible to form uniform coating films having an excellent film quality over the large area on the jigs by setting each of the relative angle β1, which was the relative angle between the raw material gas group A ejection ports 116, and the relative angle β2, which was the relative angle between the raw material gas group B ejection ports 117, to 130° or more. On the other hand, in Example 107, in which the relative angles β1 and β2 were set to 120°, the difference of the residual chloride amounts at the inner and outer circumferential sides shown in Table 6 was relatively high. In Example 109, in which the relative anglesβ1 and β2 were set to 30°, the average A1 content shown in Table 7 was low compared to the other Examples.

### Industrial Applicability

As described above, the chemical vapor deposition apparatus and the chemical vapor deposition method of the present invention provide sufficient industrial applicability particularly on aspects of saving energy and reducing the cost, since they make it possible for uniform coating films to be formed over the large area even in the case where deposition using the gas species that are highly reactive each other as raw material gas groups, which conventionally involves difficulty, is performed.

In addition, the chemical vapor deposition apparatus and the chemical vapor deposition method of the present invention is not only effective on producing the surface-coated cutting tools covered by the hard layers, but also can be used on a variety of deposition materials covered by all kinds of vapor-deposited films, such as deposition on press dies requiring abrasion resistance; and mechanical parts requiring sliding characteristics.

### Reference Signs List

1: Baseplate
2, 102: Rotary drive device (motor)
3: Gas feeding part
4: gas exhaust part
5, 105, 105A: Gas supply tube
6, 106: reaction chamber
7: Outside thermal heater
8: Gas inlet
9: Gas outlet
10: Gas inlet pipe
11: Gas exhaust pipe
12: Rotary gas introduction part
13: Center of the rotation axis of the gas supply tube
14, 114: Area A (the section in which the raw material gas group A flows (the first gas flowing section))
15, 115: Area B (the section in which the raw material gas group B flows (the second gas flowing section))
16, 116: Ejection port A (the ejection port that the raw material gas group A is ejected (the first gas ejection port))
17, 117: Ejection port B (the ejection port that the raw material gas group B is ejected (the second gas ejection port))
18: Center of the ejection port A
19: Center of the ejection port B
20: Distance between the centers of the paired ejection ports A and B
21: Angle formed by connecting the center of the ejection port A, the center of rotation axis of the gas supply tube, and the center of the ejection port B projected on the surface perpendicular to the rotation axis in the paired ejection ports A and B
22, 122: Axis of rotation of the gas supply tube (the rotation axis)
23: Plane, the normal of which is the rotation axis of the gas supply tube
24, 124: Paired ejection ports A and B (the ejection port pair)
25: Ejection port pair, in which the ejection port A precedes the ejection port B in rotation
26: Ejection port pair, in which the ejection port B precedes the ejection port A in rotation
27: Raw material gas group A inlet
28: Raw material gas group B inlet
29: Raw material gas group A introduction pipe
30: Raw material gas group B introduction pipe
31: Raw material gas group A introduction path
32: Raw material gas group B introduction path
110: Chemical vapor deposition apparatus

## Claims

1. A chemical vapor deposition apparatus (110) comprising:
a reaction chamber (106) in which deposition materials are housed;
a gas supply tube (105) provided in the reaction chamber (106);
a rotary drive device (102) that rotates the gas supply tube (105) about a rotation axis (122) of the gas supply tube (105) in the reaction chamber (106), and
a rotary gas introduction part (112) that is connected to the rotary drive device (102) through a coupling (102a), wherein
an inside of the gas supply tube (105) is divided into a first gas flowing section and a second gas flowing section, both of which extend along with the rotation axis (122),
a first gas ejection port (116), which ejects a first gas flowing in the first gas flowing section into the reaction chamber (106), and a second gas ejection port (117), which ejects a second gas flowing in the second gas flowing section into the reaction chamber (106), are provided adjoiningly on a tube wall of the gas supply tube (105) in a circumferential direction of the rotation axis (122),
the first gas ejection port (116) and the second gas ejection port (117) form a pair in a plane, a normal line of which corresponds to the rotation axis (122), and
the rotary gas introduction part (112) comprises a first through hole (112a) and a second through hole (112b), each of which passes through a side wall of the rotary gas introduction part (112), the first through hole (112a) being located at a position closer to the gas supply tube (105) than the second through hole (112b) in a direction of the rotation axis (122),
the rotary gas introduction part (112) further comprises a sealing (112c) that is provided between the first through hole (112a) and the second through hole (112b) in the direction of the rotation axis (122), the sealing (112c), the first through hole (112a) and the second through hole (112b) being provided and being configured to separate a first raw material gas group A flowing into the first through hole (112a) and a second raw material gas group B flowing into the second through hole (112b), and
a partition (105a,135) is provided in an inside of the rotary gas introduction part (112), the partition (105a,135) being configured such that the first raw material gas group A and the second raw material gas group B are separately introduced to the first gas flowing section (114) and the second gas flowing section (115), respectively.

2. The chemical vapor deposition apparatus (110) according to Claim 1, wherein a plurality of the ejection port pairs (124), each of which is made of the first and second gas ejection ports (116,117) lying next to each other in the circumferential direction of the rotation axis (122), is formed in the axial direction of the gas supply tube (105).

3. The chemical vapor deposition apparatus (110) according to Claim 2, wherein a distance between centers of the first and second gas ejection ports (116,117) forming the ejection port pair (124) is shorter than a distance between a first plane (123), which includes the ejection port pair (124) and has a normal line corresponding to the rotation axis (122), and a second plane, which includes other ejection port pair (116,117) and is adjacent to the first plane in the axial direction.

4. The chemical vapor deposition apparatus (110) according to Claim 3, wherein the distance between the centers of the first and second gas ejection ports (116,117) forming the ejection port pair (124) is 2 mm to 30 mm.

5. The chemical vapor deposition apparatus (110) according to Claim 3 or 4, wherein an angle formed by connecting: the center of the first gas ejection port (116) forming the ejection port pair (124); the center of the rotation axis (122); and the center of the second gas ejection port (117) forming the ejection port pair (124) is 60° or less in a plane (123) having a normal line corresponding to the rotation axis (122).

6. The chemical vapor deposition apparatus (110) according to Claim 1, wherein a relative angle between the first and second gas ejection ports (116,117) in a plane (123) having a normal line corresponding to the rotation axis (122) about the rotation axis (122) is 150° or more and 180° and less.

7. The chemical vapor deposition apparatus (110) according to Claim 6, wherein a plurality of the ejection port pairs (124), each of which is made of the first and second gas ejection ports (116,117) lying next to each other in the circumferential direction of the rotation axis (122), is formed in the axial direction of the gas supply tube (105).

8. The chemical vapor deposition apparatus (110) according to Claim 7, wherein in 2 sets of neighboring ejection port pairs (124) in the axial direction of the rotation axis (122), a relative angle between the first gas ejection ports (116) belonging to different sets of ejection port pairs (124); and a relative angle about the rotation axis (122) between the second gas ejection ports (117) belonging to different sets of ejection port pairs (124) about the rotation axis (122), are 130° or more.

9. The chemical vapor deposition apparatus (110) according to Claim 7 or 8, wherein in 2 sets of neighboring ejection port pairs (124) in the axial direction of the rotation axis (122), a relative angle between the first gas ejection port (116) and the second gas ejection port (117) belonging to different sets of ejection port pairs (124) is 60° or less.

10. A chemical vapor deposition method comprising the step of forming a coating film on a surface of a deposition material by using the chemical vapor deposition apparatus (110) according to any one of Claims 1 to 9.

11. The chemical vapor deposition method according to Claim 10, wherein the gas supply tube (105) is rotated in a revolution speed of 10 revolutions/minute or more and 60 revolutions/minute or less.

12. The chemical vapor deposition method according to Claim 11 or 12, wherein a raw material gas free of a metal element is used as the first gas, and a raw material gas containing a metal element is used as the second gas.

13. The chemical vapor deposition method according to Claim 12, wherein a raw material gas containing ammonia is used as the first gas.

## Patentansprüche

1. Einrichtung zur chemischen Dampfphasenabscheidung (110), umfassend:
eine Reaktionskammer (106), in der Abscheidungsmaterialien untergebracht sind;
ein Gaszufuhrrohr (105), das in der Reaktionskammer (106) bereitgestellt ist;
eine Drehantriebsvorrichtung (102), die das Gaszufuhrrohr (105) um eine Drehachse (122) des Gaszufuhrrohrs (105) in der Reaktionskammer (106) dreht, und
ein drehbares Gaseinleitungsteil (112), das über eine Kupplung (102a) mit der Drehantriebsvorrichtung (102) verbunden ist, wobei
ein Inneres des Gaszufuhrrohrs (105) in einen ersten Gasströmungsabschnitt und einen zweiten Gasströmungsabschnitt unterteilt ist, die sich beide entlang der Drehachse (122) erstrecken,
eine erste Gasausstoßöffnung (116), die ein erstes Gas, das in dem ersten Gasströmungsabschnitt strömt, in die Reaktionskammer (106) ausstößt, und eine zweite Gasausstoßöffnung (117), die ein zweites Gas, das in dem zweiten Gasströmungsabschnitt strömt, in die Reaktionskammer (106) ausstößt, nebeneinander an einer Rohrwand des Gaszufuhrrohrs (105) in einer Umfangsrichtung der Drehachse (122) bereitgestellt sind,
die erste Gasausstoßöffnung (116) und die zweite Gasausstoßöffnung (117) ein Paar in einer Ebene bilden, deren Normale der Drehachse (122) entspricht, und
der drehbare Gaseinleitungsteil (112) ein erstes Durchgangsloch (112a) und ein zweites Durchgangsloch (112b) umfasst, von denen jedes durch eine Seitenwand des drehbaren Gaseinleitungsteils (112) verläuft, wobei das erste Durchgangsloch (112a) an einer Position befindlich ist, die in Richtung der Drehachse (122) näher am Gaszufuhrrohr (105) liegt als das zweite Durchgangsloch (112b),
der drehbare Gaseinleitungsteil (112) weiter eine Dichtung (112c) umfasst, die zwischen dem ersten Durchgangsloch (112a) und dem zweiten Durchgangsloch (112b) in der Richtung der Drehachse (122) bereitgestellt ist, wobei die Dichtung (112c), das erste Durchgangsloch (112a) und das zweite Durchgangsloch (112b) bereitgestellt und konfiguriert sind, um eine erste Rohmaterialgasgruppe A, die in das erste Durchgangsloch (112a) strömt, und eine zweite Rohmaterialgasgruppe B, die in das zweite Durchgangsloch (112b) strömt, zu trennen, und
eine Trennwand (105a, 135) im Inneren des drehbaren Gaseinleitungsteils (112) bereitgestellt ist, wobei die Trennwand (105a, 135) so konfiguriert ist, dass die erste Rohmaterialgasgruppe A und die zweite Rohmaterialgasgruppe B jeweils getrennt in den ersten Gasströmungsabschnitt (114) und den zweiten Gasströmungsabschnitt (115) eingeleitet werden.

2. Einrichtung zur chemischen Dampfphasenabscheidung (110) nach Anspruch 1, wobei in axialer Richtung des Gaszufuhrrohrs (105) eine Vielzahl der Ausstoßöffnungspaare (124) gebildet ist, von denen jedes aus den ersten und zweiten Gasausstoßöffnungen (116, 117) besteht, die in Umfangsrichtung der Drehachse (122) nebeneinanderliegen.

3. Einrichtung zur chemischen Dampfphasenabscheidung (110) nach Anspruch 2, wobei ein Abstand zwischen den Mittelpunkten der ersten und zweiten Gasausstoßöffnungen (116, 117), die das Ausstoßöffnungspaar (124) bilden, kleiner ist als ein Abstand zwischen einer ersten Ebene (123), die das Ausstoßöffnungspaar (124) einschließt und eine Normale aufweist, die der Drehachse (122) entspricht, und einer zweiten Ebene, die das andere Ausstoßöffnungspaar (116, 117) einschließt und in der axialen Richtung an die erste Ebene angrenzt.

4. Einrichtung zur chemischen Dampfphasenabscheidung (110) nach Anspruch 3, wobei der Abstand zwischen den Mittelpunkten der ersten und zweiten Gasausstoßöffnung (116, 117), die das Ausstoßöffnungspaar (124) bilden, 2 mm bis 30 mm beträgt.

5. Einrichtung zur chemischen Dampfphasenabscheidung (110) nach Anspruch 3 oder 4, wobei ein Winkel, der durch Verbinden: der Mitte der ersten Gasausstoßöffnung (116), die das Ausstoßöffnungspaar (124) bildet; der Mitte der Drehachse (122); und der Mitte der zweiten Gasausstoßöffnung (117), die das Ausstoßöffnungspaar (124) bildet, gebildet wird, 60° oder weniger in einer Ebene (123) beträgt, die eine Normale aufweist, die der Drehachse (122) entspricht.

6. Einrichtung zur chemischen Dampfphasenabscheidung (110) nach Anspruch 1, wobei ein relativer Winkel zwischen den ersten und zweiten Gasausstoßöffnungen (116, 117) in einer Ebene (123), die eine Normale aufweist, die der Drehachse (122) entspricht, um die Drehachse (122) 150° oder mehr und 180° und weniger beträgt.

7. Einrichtung zur chemischen Dampfphasenabscheidung (110) nach Anspruch 6, wobei in axialer Richtung des Gaszufuhrrohrs (105) eine Vielzahl der Ausstoßöffnungspaare (124) ausgebildet ist, von denen jedes aus den ersten und zweiten Gasausstoßöffnungen (116, 117) besteht, die in Umfangsrichtung der Drehachse (122) nebeneinanderliegen.

8. Einrichtung zur chemischen Dampfphasenabscheidung (110) nach Anspruch 7, wobei in 2 Sätzen von benachbarten Ausstoßöffnungspaaren (124) in der axialen Richtung der Drehachse (122) ein relativer Winkel zwischen den ersten Gasausstoßöffnungen (116), die zu verschiedenen Sätzen von Ausstoßöffnungspaaren (124) gehören; und ein relativer Winkel um die Drehachse (122) zwischen den zweiten Gasausstoßöffnungen (117), die zu verschiedenen Sätzen von Ausstoßöffnungspaaren (124) gehören, 130 ° oder mehr beträgt.

9. Einrichtung zur chemischen Dampfphasenabscheidung (110) nach Anspruch 7 oder 8, wobei in 2 Sätzen von benachbarten Ausstoßöffnungspaaren (124) in der axialen Richtung der Drehachse (122) ein relativer Winkel zwischen der ersten Gasausstoßöffnung (116) und der zweiten Gasausstoßöffnung (117), die zu verschiedenen Sätzen von Ausstoßöffnungspaaren (124) gehören, 60 ° oder weniger beträgt.

10. Verfahren zur chemischen Dampfphasenabscheidung, umfassend den Schritt der Bildung eines Beschichtungsfilms auf einer Oberfläche eines Abscheidungsmaterials unter Verwendung der chemischen Einrichtung zur chemischen Dampfphasenabscheidung (110) nach einem der Ansprüche 1 bis 9.

11. Verfahren zur chemischen Dampfphasenabscheidung nach Anspruch 10, wobei das Gaszufuhrrohr (105) mit einer Drehzahl von 10 Umdrehungen/Minute oder mehr und 60 Umdrehungen/Minute oder weniger gedreht wird.

12. Verfahren zur chemischen Dampfphasenabscheidung nach Anspruch 11 oder 12, wobei ein Rohmaterialgas, das frei von einem Metallelement ist, als das erste Gas und ein Rohmaterialgas, das ein Metallelement enthält, als das zweite Gas verwendet wird.

13. Verfahren zur chemischen Dampfphasenabscheidung nach Anspruch 12, wobei als erstes Gas ein ammoniakhaltiges Rohmaterialgas verwendet wird.

## Revendications

1. Appareil de dépôt chimique en phase vapeur (110) comprenant :
une chambre de réaction (106) dans laquelle des matériaux de dépôt sont logés ;
un tuyau d'alimentation en gaz (105) prévu dans la chambre de réaction (106) ;
un dispositif d'entraînement rotatif (102) qui fait tourner le tuyau d'alimentation en gaz (105) autour d'un axe de rotation (122) du tuyau d'alimentation en gaz (105) dans la chambre de réaction (106), et
une partie d'introduction de gaz rotative (112) qui est connectée au dispositif d'entraînement rotatif (102) par l'intermédiaire d'un couplage (102a), dans lequel
un intérieur du tuyau d'alimentation en gaz (105) est divisé en une première section de circulation de gaz et une seconde section de circulation de gaz, toutes deux s'étendant le long de l'axe de rotation (122),
un premier orifice d'éjection de gaz (116), qui éjecte un premier gaz circulant dans la première section de circulation de gaz jusque dans la chambre de réaction (106), et un second orifice d'éjection de gaz (117), qui éjecte un second gaz circulant dans la seconde section de circulation de gaz jusque dans la chambre de réaction (106), sont prévus de manière contiguë sur une paroi de tuyau du tuyau d'alimentation en gaz (105) dans une direction circonférentielle de l'axe de rotation (122),
le premier orifice d'éjection de gaz (116) et le second orifice d'éjection de gaz (117) forment une paire dans un plan, dont une ligne normale correspond à l'axe de rotation (122), et
la partie d'introduction de gaz rotative (112) comprend un premier trou traversant (112a) et un second trou traversant (112b), dont chacun passe à travers une paroi latérale de la partie d'introduction de gaz rotative (112), le premier trou traversant (112a) étant situé à une position plus proche du tuyau d'alimentation en gaz (105) que le second trou traversant (112b) dans une direction de l'axe de rotation (122),
la partie d'introduction de gaz rotative (112) comprend en outre un joint d'étanchéité (112c) qui est prévu entre le premier trou traversant (I12a) et le second trou traversant (112b) dans la direction de l'axe de rotation (122), le joint d'étanchéité (112c), le premier trou traversant (112a) et le second trou traversant (112b) étant prévus et configurés pour séparer un premier groupe de gaz de matière première A circulant dans le premier trou traversant (112a) et un second groupe de gaz de matière première B circulant dans le second trou traversant (112b), et
une cloison (105a, 135) est prévue dans un intérieur de la partie d'introduction de gaz rotative (112), la cloison (105a, 135) étant configurée de telle sorte que le premier groupe de gaz de matière première A et le second groupe de gaz de matière première B sont introduits séparément dans la première section de circulation de gaz (114) et la seconde section de circulation de gaz (115), respectivement.

2. Appareil de dépôt chimique en phase vapeur (110) selon la revendication 1, dans lequel une pluralité des paires d'orifices d'éjection (124), dont chacune est constituée des premier et second orifices d'éjection de gaz (116, 117) se trouvant l'un à côté de l'autre dans la direction circonférentielle de l'axe de rotation (122), est formée dans la direction axiale du tuyau d'alimentation en gaz (105).

3. Appareil de dépôt chimique en phase vapeur (110) selon la revendication 2, dans lequel une distance entre des centres des premier et second orifices d'éjection de gaz (116, 117) formant la paire d'orifices d'éjection (124) est plus courte qu'une distance entre un premier plan (123), qui inclut la paire d'orifices d'éjection (124) et présente une ligne normale correspondant à l'axe de rotation (122), et un second plan, qui inclut une autre paire d'orifices d'éjection (116, 117) et est adjacent au premier plan dans la direction axiale.

4. Appareil de dépôt chimique en phase vapeur (110) selon la revendication 3, dans lequel la distance entre les centres des premier et second orifices d'éjection de gaz (116, 117) formant la paire d'orifices d'éjection (124) est de 2 mm à 30 mm.

5. Appareil de dépôt chimique en phase vapeur (110) selon la revendication 3 ou 4, dans lequel un angle formé en connectant : le centre du premier orifice d'éjection de gaz (116) formant la paire d'orifices d'éjection (124) ; le centre de l'axe de rotation (122) ; et le centre du second orifice d'éjection de gaz (117) formant la paire d'orifices d'éjection (124) est de 60° ou moins dans un plan (123) présentant une ligne normale correspondant à l'axe de rotation (122).

6. Appareil de dépôt chimique en phase vapeur (110) selon la revendication 1, dans lequel un angle relatif entre les premier et second orifices d'éjection de gaz (116, 117) dans un plan (123) présentant une ligne normale correspondant à l'axe de rotation (122) autour de l'axe de rotation (122) est de 150° ou plus et de 180° et moins.

7. Appareil de dépôt chimique en phase vapeur (110) selon la revendication 6, dans lequel une pluralité de paires d'orifices d'éjection (124), dont chacune est constituée des premier et second orifices d'éjection de gaz (116, 117) se trouvant l'un à côté de l'autre dans la direction circonférentielle de l'axe de rotation (122), est formée dans la direction axiale du tuyau d'alimentation en gaz (105).

8. Appareil de dépôt chimique en phase vapeur (110) selon la revendication 7, dans lequel dans 2 ensembles de paires d'orifices d'éjection voisins (124) dans la direction axiale de l'axe de rotation (122), un angle relatif entre les premiers orifices d'éjection de gaz (116) appartenant à différents ensembles de paires d'orifices d'éjection (124) ; et un angle relatif autour de l'axe de rotation (122) entre les seconds orifices d'éjection de gaz (117) appartenant à différents ensembles de paires d'orifices d'éjection (124) autour de l'axe de rotation (122), sont de 130° ou plus.

9. Appareil de dépôt chimique en phase vapeur (110) selon la revendication 7 ou 8, dans lequel dans 2 ensembles de paires d'orifices d'éjection voisins (124) dans la direction axiale de l'axe de rotation (122), un angle relatif entre le premier orifice d'éjection de gaz (116) et le second orifice d'éjection de gaz (117) appartenant à différents ensembles de paires d'orifices d'éjection (124) est de 60° ou moins.

10. Procédé de dépôt chimique en phase vapeur comprenant l'étape de formation d'un film de revêtement sur une surface d'un matériau de dépôt en utilisant l'appareil de dépôt chimique en phase vapeur (110) selon l'une quelconque des revendications 1 à 9.

11. Procédé de dépôt chimique en phase vapeur selon la revendication 10, dans lequel le tuyau d'alimentation en gaz (105) est mis en rotation à une vitesse de rotation de 10 tours/minute ou plus et de 60 tours/minute ou moins.

12. Procédé de dépôt chimique en phase vapeur selon la revendication 11 ou 12, dans lequel un gaz de matière première exempt d'un élément métallique est utilisé en tant que premier gaz, et un gaz de matière première contenant un élément métallique est utilisé en tant que second gaz.

13. Procédé de dépôt chimique en phase vapeur selon la revendication 12, dans lequel un gaz de matière première contenant de l'ammoniac est utilisé en tant que premier gaz.
